(19) Europäisches Patentamt
European Patent Office
Office européen des brevets

(11) EP 2 884 413 B1

(12) **EUROPEAN PATENT SPECIFICATION**

(45) Date of publication and mention of the grant of the patent:
**09.10.2019 Bulletin 2019/41**

(21) Application number: **13828344.5**

(22) Date of filing: **06.08.2013**

(51) Int Cl.:
***G01W 1/10*** *(2006.01)*

(86) International application number:
**PCT/KR2013/007077**

(87) International publication number:
**WO 2014/025188 (13.02.2014 Gazette 2014/07)**

(54) **METHOD FOR PREDICTING WIND POWER DENSITY**

VERFAHREN ZUR VORHERSAGE EINER WINDENERGIEDICHTE

PROCÉDÉ DE PRÉDICTION DE LA DENSITÉ DE PUISSANCE DU VENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.08.2012 KR 20120086228**
**07.08.2012 KR 20120086236**
**07.08.2012 KR 20120086262**

(43) Date of publication of application:
**17.06.2015 Bulletin 2015/25**

(73) Proprietor: **Korea Institute of Energy Research**
**Daejeon 305-343 (KR)**

(72) Inventors:
- **KIM, Hyun-Goo**
  **Daejeon 305-759 (KR)**
- **LEE, Yung-Seop**
  **Seoul 142-761 (KR)**

(74) Representative: **Stolmár & Partner**
**Patentanwälte PartG mbB**
**Blumenstraße 17**
**80331 München (DE)**

(56) References cited:
**JP-A- H1 193 824 US-A1- 2012 065 886**

- **MEHMET BILGILI ET AL: "Comparative analysis of regression and artificial neural network models for wind speed prediction", METEOROLOGY AND ATMOSPHERIC PHYSICS, SPRINGER-VERLAG, VI, vol. 109, no. 1 - 2, 9 October 2010 (2010-10-09), pages 61-72, XP019856700, ISSN: 1436-5065, DOI: 10.1007/S00703-010-0093-9**
- **COSTA A ET AL: "A review on the young history of the wind power short-term prediction", RENEWABLE AND SUSTAINABLE ENERGY REVIEWS, ELSEVIERS SCIENCE, NEW YORK, NY, US, vol. 12, no. 6, 1 August 2008 (2008-08-01) , pages 1725-1744, XP022638001, ISSN: 1364-0321, DOI: 10.1016/J.RSER.2007.01.015 [retrieved on 2008-05-02]**
- **KIM, HYUN-GOO ET AL.: 'Development of the Wind Power Forecasting System, KIER Forecaster' JOURNAL OF KSNRE vol. 2, no. 2, 2006, XP055196826**
- **CHAE, BYEONG GON ET AL.: 'Development of a Logistic Regression Model for Probabilistic Prediction of Debris Flow' THE JOURNAL OF ENGINEERING GEOLOGY vol. 14, no. 2, June 2004, pages 211 - 222, XP008176753**
- **LEE, YONG - JUN ET AL.: 'Analysis of Landslide Hazard Area using Logistic Regression Analysis and AHP (Analytical Hierarchy Process) Approach' CONFERENCE JOURNAL 2006, pages 2001 - 2005, XP008176777**
- **SEO, HYEON SU ET AL.: 'Analysis on Wind Characteristics for Offshore Wind Turbine Structure Design at Waljeong, Jejudo' JOURNAL OF WEIK vol. 14, no. 3, 2010, pages 161 - 167, XP008176752**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 884 413 B1

## Description

[Technical Field]

The present invention relates to a method for predicting a wind power density.

More particularly, first, the present invention relates to a method for predicting a wind power density using a stepwise regression analysis technique of providing a regression model capable of estimating a wind power density at any point using a stepwise variable selection technique of performing an analysis while adding statistically important terms or removing statistically meaningless terms, as a method of selecting variables that are to be used in a multiple regression analysis using a linear relationship between variables belonging to a data set. Second, the present invention relates to a method for predicting a wind power density using a main component analysis technique of providing a linear regression analysis model capable of estimating a linear relationship with a wind power density, which is an output variable, by classifying input variables into a plurality of main component input variables configured of linear combinations using a variance/covariance relationship and using the classified main component input variables as new input variables between which multicollinearity is not present. Third, the present invention relates to a method for predicting a wind power density using a neural network analysis technique of predicting a wind power density at any point by modeling a non-linear relationship between variables having a complicated structure through the neural network analysis technique of using variables selected by a stepwise variable selection method as input variables and using values obtained by transforming a wind power density as output variables.

[Background Art]

The center of global wind power energy development has moved from Europe to the Pacific Ocean. The United States, China, and India have challenged positions of traditional wind power advanced countries of Europe, and latecomers such as England, and the like, for offshore wind power have accomplished a remarkable result.

The United States has selected and analyzed topographic and meteorological factors as core elements in order to decide an amount of latent onshore wind power resource. The national renewable energy laboratory (NREL) has provided a reference index for validity of wind power generation by dividing a wind power grade based on a wind power density.

Denmark studied spatial distribution characteristics of a wind power density using an actually measured wind and a numerical wind, that is, a microscopic scale air flow model and a middle scale air flow model corresponding to a wide region in order to accurately diagnose and evaluate a wind power resource and establish a plan for the wind power resource. Among them, it is required in the present invention to review that the most basic and common data for calculating the actually measured wind and the numerical wind are terrain factors such as a terrain elevation, a terrain slope, a ground roughness, and the like. It has been disclosed that terrain data such as a latitude, a longitude, a contour line, and the like, representing a terrain feature such as a mountain or a valley, and ground data such as a ground roughness, and the like, representing a ground feature such as a grassland, a forest, and a city are utilized as core input data.

It is judged that common use of the terrain and ground data in calculating a microscopic scale or middle scale numerical wind assumes that a wind power resource has high association with the terrain and ground features. Therefore, in the present invention, it is considered that terrain related factors such as the terrain elevation, the terrain slope, the ground roughness, and the like, together with meteorology related factors are included in analysis data based on this scientific inference.

In Korea, since various and complicated terrain features appear in a narrow area, a study on a relationship between a local scale terrain and a wind power resource has been mainly conducted. Particularly, a study on Tae Baek Mountains of Gang Won Do in which a very strong wind appears has been mainly conducted. In addition, a study on a technique of calculating an amount of power that may be generated at the time of installing a wind power generator using the actually measured wind rather than an analysis on various terrain factors has been mainly conducted.

According to a study by Kim Jung Hoon, et al. (2006), a strong wind that appears in the Yeong Dong region during spring, which is mainly a west wind, is mainly associated with mountains. Han Sun Ho, et al., (2007) analyzed an influence of asymmetry of a terrain of Tae Baek Mountains on a wind field in connection with that the terrain of Tae Baek Mountains has a gentle slope toward the west and has a rapid slope toward the east through a numerical simulation.

As a result, it has been revealed that maximum strong wind power appeared about two hours more quickly in an asymmetric mountain terrain than in a bilateral symmetrical mountain terrain and strong wind power was continued for about four hours at a place vertically lower by about 0.5km.

In addition, in the case of a ground wind speed, a wind speed of a terrain in which a slope of a downwind side mountain inclined surface is asymmetrically steep is increased until any region, but is decreased after the region.

This study may be considered as the case showing that various terrain factors have an influence on the wind power resource by taking the asymmetry of the terrain as well as the slope into consideration.

Chung Woo Sik, et al., (2009) have explained that ten or more wind system regions are present in South Korea by classifying regions having the same meteorological feature into one wind system using a numerical wind and important factors for dividing these wind system regions are terrain features.

Meanwhile, there is a study of Kim Hyon Goo (2011) making a wind power resource map of the Korean peninsula by calculating a numerical wind using a middle scale air flow model in which various meteorology and terrain factors are considered in order to calculate an amount of latent wind power resource in the Korea peninsula and select a place suitable for building a wind power generation farm.

M.Bilgili and B.Sahin describe a study in which wind speed is modeled by linear regression, nonlinear regression and artificial neural network methods. Their findings are published as "Comparative analysis of regression and artificial neural network models for wind speed prediction" in Meteorol Atmos Phys (2010) 109: pp.61-72.

In the future, in order to preoccupy a leading position in wind power generation competition between nations that is to be fierce, each nation has competitively made a wind power resource map and has used the wind power resource map as core data for making a wind power generation national strategy and an execution policy.

Therefore, in accordance with a precision work of the wind power resource map, a study on extracting main variables having an influence on a wind power density among meteorology, terrain, and ground features of a land region to secure a statistical model corresponds to a basic study of a wind power field for raising the understanding for the wind power resource.

Korean Patent No. 10-1020638 (hereinafter, referred to as Related Art Document 1) entitled "Method of Calculating Future Energy Consumption" has disclosed a technical content for a method of calculating future energy consumption, and Korean Patent Laid-Open Publication No. 2005-0063616 (hereinafter, referred to as Related Art Document 2) entitled "Wind Resource Mapping Method" has disclosed a technical content for a wind resource mapping method using a numerical wind.

However, since the related art in which the wind power density is calculated by calculating the numerical wind using the microscopic scale air flow model or the middle scale air flow model, such as Denmark, Related Art Document 2, and the like, requires a vast amount of computer resource and calculation time in order to analyze a governed equation of an air flow in a numerical analysis scheme, a vast amount of cost are required in order to predict a wind power density at any region.

[Related Art Document]

[Patent Document]

Korean Patent No. 10-1020638
Korean Patent Laid-Open Publication No. 2005-0063616

[Disclosure]

[Technical Problem]

An object of the present invention is to provide a method for predicting a wind power density capable of predicting a wind power density at any region so as to provide a geographical statistical methodology about a wind power density using a statistical analysis of a stepwise regression analysis technique of input variables, which are geographical elements, provide a geographical statistical methodology about a wind power density, which is an output variable, by performing a main component analysis technique on input variables, which are geographical elements, to classify the input variables into a plurality of main component input variables and regression-analyzing the classified main component input variables and dummy variables, or provide a geographical statistical methodology about a wind power density through a neural network analysis technique using a stepwise variable selection method.

[Technical Solution]

In one general aspect, a method for predicting a wind power density using a stepwise regression analysis technique, as in claim 1 is defined.

The ground roughnesses (r1 to r6) may indicate types of grounds depending on utilization of a land, the aspects (a1 to a7) may indicate directions of inclined surfaces, the elevation (DEM) may indicate an elevation value of a lattice divided from a terrain and having a predetermined size, the relative elevation difference may indicate a comparison value between an elevation of a target region and elevations of surrounding regions, the mean elevation may indicate a mean of elevations of the target region, the maximum elevation may indicate a maximum value of the elevations of the target region, the minimum elevation may indicate a minimum value of the elevations of the target region, the relative relief may indicate a difference between the maximum elevation and the minimum elevation, the terrain openness may indicate a value obtained by measuring how much the target region is not topologically closed when the target region and the surrounding regions are compared with each other, the wide region terrain openness may indicate a value obtained by measuring how much the target region is not topologically closed when the target region is compared with surrounding regions wider than the terrain openness, the slope may indicate the most rapid descent surface of the target region, the relative slope may indicate a difference between a first mean slope of the target region and the surrounding and a second mean slope of surrounding regions wider than the first mean slope, the distance from the coast may indicate linear distances from each of the East Sea, the West Sea, and the South Sea of Korea to the target region, and the reinterpretation meteorology data may correspond to global weather observation data and numerical analysis data re-processed at a spatial resolution of several tens of kilometers or more and distributed for free for a weather forecast, and may be any one selected among NCEP/NCAR (National Center for Environmental Prediction-National Center for Atmospheric Research), MERRA (NASA's Modern-Era Retrospective Analysis for Research and Applications), ECMWF (European Center for Medium-range Weather Forecasts) of Europe, and JRA-25 (The 25-year Japanese ReAnalysis) of Japan.

The stepwise regression analyzing step (S2) may include: a variable transforming step (S21) of performing one or more of variable transformations of the output variable and the input variables input in the variable inputting step (S1) and performing a variable standardization in order to solve a unit difference between the output variable and the input variables; a normality deciding step (S22) of deciding normality of each of the output variable and the input variables transformed in the variable transforming step (S21); an output variable inputting step (S23) of inputting any one selected from the output variable input in the variable inputting step (S1) and the transformed output variable decided to have the normality in the normality deciding step (S22); an input variable inputting step (S24) of inputting input variables obtained by transforming input variables using nominal variables into dummy variables in the variable transforming step (S21) and inputting any one selected among input variables of the same components of input variables that are not the nominal variables input in the variable inputting step (S1) and the transformed input variables decided to have the normality in the normality deciding step (S22) per input variable input in the variable inputting step (S1); a stepwise regression analysis multiple performing step (S25) of receiving the output variable input in the output variable inputting step (S23) and the input variables input in the input variable inputting step (S24), respectively, and performing the regression analysis method by the stepwise variable selection method once or more; and an optimal stepwise regression analysis data selecting step (S26) of selecting a regression analysis result by the stepwise variable selection method having the highest Coefficient of determination($R^2$) value among resultant values of each stepwise regression analysis derived by performing the stepwise regression analysis multiple performing step (S25).

The variable transformation of the variable transforming step (S21) may be any one selected among an original variable, a log transformation, and a square root transformation.

The multiple regression equation predicting an onshore wind power density of a terrain of South Korea may be

$$\log(\text{wind power density}) = 3.79969 + \left(0.05551 \times \sqrt{\text{reinterpretation meteorological data}}\right) + \left(0.04374 \times \sqrt{\text{elevation}}\right) + \left(-0.00260 \times \sqrt{\text{distance from coast}}\right) + \left(-0.01867 \times \sqrt{\text{minimum elevation}}\right) + \left(0.09367 \times \sqrt{\text{slope}}\right) + (0.00446 \times \text{wide region terrain openness}) + \left(0.02753 \times \sqrt{\text{mean elevation}}\right) + (-0.00569 \times \text{terrain openness}) + (0.00075229 \times \text{relative elevation}) + (-0.02608 \times \text{relative slope}) + \left(0.01661 \times \sqrt{\text{relative relief}}\right) + \left(-0.02137 \times \sqrt{\text{maximum elevation}}\right) + (0.24603 \times r1) + (0.12644 \times r2) + (0.10458 \times r3) + (0.12340 \times r4) + (0.15980 \times r5) + (0.00345 \times r6) + (0.05231 \times a1) + (0.08932 \times a2) + (0.05164 \times a3) + (-0.00168 \times a4) + (-0.03096 \times a5) + (-0.06323 \times a6) + (-0.04673 \times a7),$$

where r1 to r6 are dummy variables of the ground roughnesses and a1 to a7 are dummy variables of the aspects.

An Coefficient of determination($R^2$) value of the multiple regression equation predicting the onshore wind power density of the terrain of the South Korea may be 0.6267.

In another general aspect, a method for predicting a wind power density using a main component analysis technique, as in claim 5 is defined.

The ground roughnesses (r1 to r6) may indicate types of grounds depending on utilization of a land, the aspects (a1 to a7) may indicate directions of inclined surfaces, the elevation (DEM) may indicate an elevation value of a lattice divided from a terrain and having a predetermined size, the relative elevation difference may indicate a comparison value between an elevation of a target region and elevations of surrounding regions, the mean elevation may indicate a mean of elevations of the target region, the maximum elevation may indicate a maximum value of the elevations of the target region, the minimum elevation may indicate a minimum value of the elevations of the target region, the relative relief may indicate a difference between the maximum elevation and the minimum elevation, the terrain openness may indicate a value obtained by measuring how much the target region is not topologically closed when the target region and the surrounding regions are compared with each other, the wide region terrain openness may indicate a value obtained by measuring how much the target region is not topologically closed when the target region is compared with surrounding regions wider than the terrain openness, the slope may indicate the most rapid descent surface of the target region, the relative slope may indicate a difference between a first mean slope of the target region and the surrounding and a second mean slope of surrounding regions wider than the first mean slope, the distance from the coast may indicate linear distances from each of the East Sea, the West Sea, and the South Sea of Korea to the target region, and the reinterpretation meteorology data may correspond to global weather observation data and numerical analysis data re-processed at a spatial resolution of several tens of kilometers or more and distributed for free for a weather forecast, and may be any one selected among NCEP/NCAR (National Center for Environmental Prediction-National Center for Atmospheric Research), MERRA (NASA's Modern-Era Retrospective Analysis for Research and Applications), ECMWF (European Center for Medium-range Weather Forecasts) of Europe, and JRA-25 (The 25-year Japanese ReAnalysis) of Japan.

The regression analyzing step (S30) may include: a variable selecting step (S31) of selecting one or more main component of which the eigenvalue is a pre-input first predetermined value or more or the cumulative value is smaller than a pre-input second predetermined value among the plurality of main components analyzed in the main component analyzing step (S20); a variable transforming step (S32) of performing variable transformations on the output variable input in the variable inputting step (S10); a normality deciding step (S33) of deciding normality of the output variable transformed in the variable transforming step (S32); an output variable inputting step (S34) of inputting any one selected from the output variable input in the variable inputting step (S10) and the standardized output variable decided to have the normality in the normality deciding step (S33); an input variable inputting step (S35) of inputting one or more selected among the input variables configuring the main components selected in the variable selecting step (S31); and a regression analysis multiple performing step (S36) of receiving the output variable input in the output variable inputting step (S34), the input variable input in the input variable inputting step (S35), and the dummy variables input in the variable inputting step (S10), respectively, and performing the regression analysis by the stepwise variable selection method once or more.

The variable transformation of the variable transforming step (S32) may be any one selected from a log transformation and a square root transformation.

The main component multiple regression equation predicting an onshore wind power density of a terrain of South Korea may be log(wind power density) = 4.87579 + (0.11583 $\times$ first main component input variable) + (0.06275 $\times$ second main component input variable) + (0.13119 $\times$ third main component input variable) + (-0.17187 $\times$ fourth main component input variable) + (0.40142 $\times$ r1) + (0.24001 $\times$ r2) + (0.20801 $\times$ r3) + (0.25655 $\times$ r4) + (0.26863 $\times$ r5) + (0.08658 $\times$ r6) + (-0.11419 $\times$ a1) + (-0.05256 $\times$ a2) + (-0.06328 $\times$ a3) + (-0.09685 $\times$ a4) + (-0.10314 $\times$ a5) + (-0.11079 $\times$ a6) + (-0.06658 $\times$ a7), where r1 to r6 are dummy variables of the ground roughnesses and a1 to a7 are dummy variables of the aspects.

An Coefficient of determination (R2) value of the main component regression equation predicting the onshore wind power density of the terrain of the South Korea may be 0.5838.

In still another general aspect, a method for predicting a wind power density using a neural network analysis technique, as in claim 9 is defined.

The ground roughnesses (r1 to r6) of the variable inputting step (S100) may indicate types of grounds depending on utilization of a land, the aspects (a1 to a7) may indicate directions of inclined surfaces, and the ground roughnesses and the aspects may be transformed into dummy variables.

The neural network analyzing step (S200) may include a first analyzing step (S210) of performing the neural network analysis using the output variable log-transformed and the input variable using the stepwise variable selection method.

The neural network analyzing step (S200) may include a second analyzing step (S220) of performing the neural network analysis using the output variable in an original data form and the input variable using the stepwise variable selection method.

The neural network analyzing step (S200) may include a third analyzing step (S230) of performing the neural network analysis using the output variable square-root-transformed and the input variable using the stepwise variable selection method.

The neural network analyzing step (S200) may include a fourth analyzing step (S240) of performing the neural network analysis using the output variable log-transformed and the input variable using the stepwise variable selection method, and the elevation, the slope, the distance from the coast, the maximum elevation, the mean elevation, the minimum elevation, the relative relief, and the reinterpretation meteorology data may be square-root-transformed.

The neural network analyzing step (S200) may include a fifth analyzing step (S250) of performing the neural network analysis using the output variable square-root-transformed and the input variable using the stepwise variable selection method, and the elevation, the slope, the distance from the coast, the maximum elevation, the mean elevation, the minimum elevation, the relative relief, and the reinterpretation meteorology data may be square-root-transformed.

[Advantageous Effects]

In the method for predicting a wind power density according to the present invention having the above-mentioned configuration, it is possible to develop a geographical statistical model about an onshore density analysis using the reinterpretation meteorology data, various terrain data, and the like, in order to prepare a scientific base in calculating an amount of latent onshore wind power resource and make a location strategy of a wind power generation farm in the future.

In addition, a wind power density statistical model may require less cost and provide an instantaneous calculating result, as compared with the related art requiring a vast amount of cost and time in predicting a wind power density at any (selection) point.

[Description of Drawings]

FIG. 1 is a flow chart showing a method for predicting a wind power density using a stepwise regression analysis technique according to a first exemplary embodiment of the present invention.

FIG. 2 is a flow chart showing a method for predicting a wind power density using a main component analysis technique according to a second exemplary embodiment of the present invention.

FIG. 3 is a flow chart showing the method for predicting a wind power density using a main component analysis technique according to a second exemplary embodiment of the present invention in detail.

FIG. 4 is a flow chart showing a method for predicting a wind power density using a neural network analysis technique according to a third exemplary embodiment of the present invention.

FIG. 5 is a view schematically showing a structure of a multi-layer perceptron (MLP) neural network in the method for predicting a wind power density using a neural network analysis technique according to a third exemplary embodiment of the present invention.

[Best Mode]

Hereinafter, a method for predicting a wind power density according to exemplary embodiments of the present invention will be described in detail with reference to the accompanying drawings. The drawings to be provided below are provided by way of example so that the idea of the present invention can be sufficiently transferred to those skilled in the art to which the present invention pertains. Therefore, the present invention is not limited to the accompanying drawings to be provided below, but may be implemented in other forms. In addition, like reference numerals denote like elements throughout the specification.

Technical terms and scientific terms used in the present specification have the general meaning understood by those skilled in the art to which the present invention pertains unless otherwise defined, and a description for the known function and configuration obscuring the gist of the present invention will be omitted in the following description and the accompanying drawings.

(First Exemplary Embodiment)

FIG. 1 is a flow chart showing a method for predicting a wind power density according to a first exemplary embodiment of the present invention. Hereinafter, the method for predicting a wind power density using a stepwise regression analysis technique according to a first exemplary embodiment of the present invention will be described in detail with reference to FIG. 1.

Generally, a regression analysis means a statistical technique of figuring out a correlation between two or more variables, that is, a correlation between a value of any specific variable (output variable) and one or more other variables (input variables) to explain and predict an output variable.

Therefore, the regression analysis may be considered as a synthetic concept of association of the correlation and causation of a causality model, and has a very strong analysis skill in analyzing a relationship, that is, a relevance, between a quantitative output variable and one or more input variables. In addition, the regression analysis may have excellent adaptability, and a general form of the regression analysis may be represented by a function relation of a linear equation.

The regression analysis may be divided into a simple regression analysis and a multiple regression analysis. The simple regression analysis means that an output variable is explained and predicted using one input variable, and the multiple regression analysis means that output variable is explained and predicted using a relationship between several input variables and the output variable.

The method for predicting a wind power density using a stepwise regression analysis technique according to a first exemplary embodiment of the present invention may include a variable inputting step (S1), a stepwise regression analyzing step (S2), and a multiple regression equation estimating step (S3).

In addition, the method for predicting a wind power density using a stepwise regression analysis technique according to a first exemplary embodiment of the present invention may be configured in a form of a program that is executed by an execution processing means including a computer.

In the variable inputting step (S1), a wind power density, which is an output variable, and one or more input variables selected among ground roughnesses, an elevation, a relative elevation difference, a terrain openness, a wide region terrain openness, aspects, a slope, a relative slope, a mean elevation, a maximum elevation, a minimum elevation, a relative relief, a distance from a coast, and reinterpretation meteorology data are input.

In the stepwise regression analyzing step (S2), the output variable and the input variables input in the variable inputting step (S1) are received, and a stepwise regression analysis method is performed.

The regression analysis indicates that data are analyzed using a model capable of explaining or predicting a value of another variable using one variable. Here, an explaining variable is called an input variable or an explanatory variable, and an explained or predicted variable is called an output variable or a response variable. The case in which the number of explaining input variables is one is called the simple regression analysis, and the case in which the number of explaining input variables is two is called the multiple regression analysis.

In the multiple regression equation estimating step (S3), a multiple regression equation having the highest coefficient of determination($R^2$) value is estimated using regression coefficients calculated in the stepwise regression analyzing step (S2).

In the method for predicting a wind power density using a stepwise regression analysis technique according to a first exemplary embodiment of the present invention, it is important to select the most effective input variables for the purpose of developing a geographical statistical model for predicting an onshore wind power density using the reinterpretation meteorology data, terrain data, and the like, in order to prepare a scientific base in calculating an amount of latent onshore wind power resource and making a location strategy of a wind power generation farm in the future.

The respective variables of the variable inputting step (S1) will be described.

A national wind map having a spatial resolution of 1km×1km, built-up by Korean Institute of Energy Research may be used as numerical wind data of the wind power density, and the wind power density may be used as the output variable. In addition, the meaning that the wind power density is high is that wind power is high, and $W/m^2$ may be used as a unit of the wind power density.

The aspect transformed into a dummy variable, which is a direction of an inclined surface, is defined as a direction in which a slope is largest at a specific point. Generally, the aspect is used in order to figure out characteristics depending on a main direction of a terrain. An aspect variable has data of 0 to 360 degrees. In order to maintain consistency of the data, 360 degrees are transformed into 0 degree, and a value of a negative number is transformed into a positive number. In order to facilitate an analysis, the aspect variable is classified into eight categories, which correspond to the north to the northeast (0 degree or more to less than 45 degrees), the northeast to the east (45 degrees or more to less than 90 degrees), the east to the southeast (90 degrees or more to less than 135 degrees), the southeast to the south (135 degrees or more to less than 180 degrees), the south to the southwest (180 degrees or more to less than 225 degrees), the southwest to the west (225 degrees or more to less than 270 degrees), the west to the northwest (270 degrees or more to less than 315 degrees), and the northwest to the north (315 degrees or more to less than 360 degrees). Here, the eight categories may be transformed into seven dummy variables (a1 to a7) and be used.

The aspects transformed into the dummy variables may be confirmed with reference to the following Table 1.

[Table 1]

| Wind Direction | | a1 | a2 | a3 | a4 | a5 | a6 | a7 |
|---|---|---|---|---|---|---|---|---|
| [0,45] | N~NE | 1 | 0 | 0 | 0 | 0 | 0 | 0 |
| [45,90] | NE~E | 0 | 1 | 0 | 0 | 0 | 0 | 0 |
| [90,135] | E~SE | 0 | 0 | 1 | 0 | 0 | 0 | 0 |
| [135,180] | SE~S | 0 | 0 | 0 | 1 | 0 | 0 | 0 |
| [180,225] | S~SW | 0 | 0 | 0 | 0 | 1 | 0 | 0 |
| [225,270] | SW~W | 0 | 0 | 0 | 0 | 0 | 1 | 0 |
| [270,315] | W~NW | 0 | 0 | 0 | 0 | 0 | 0 | 1 |
| [315,360] | NW~N | 0 | 0 | 0 | 0 | 0 | 0 | 0 |

In addition, as the ground roughness transformed into a dummy variable, which means a roughness type of a ground depending on the utilization of a land, a land cover classification map built-up in Ministry of Environment may be used. The ground roughness may be classified into a water region, an arable land, fields and paddies, a pasture, an orchard, a forest, a downtown region, and the like, and heights of corresponding roughness elements may be transformed into meters and be used depending on classification of the ground. In the case of Korea, a terrain is complicated, and a forest, a city, and a farm region are compositively present, such that a cover state is very complicated. The cover state may be used as an input variable for measuring a correlation between the ground roughness and the wind power density on the assumption that it will act as a factor accelerating or decelerating a flow of wind. In the case of using the seven categories in order to facilitate an analysis of the ground roughness, roughness heights corresponding to each category may correspond to 0.0001m, 0.05m, 0.1m, 0.15m, 0.25m, 0.5m, and 0.8m. Here, the seven categories may be transformed into six dummy variables (r1 to r6) and be used.

The ground roughnesses transformed into the dummy variables may be confirmed with reference to the following Table 2.

[Table 2]

| Utilizat ion of Land | Height of Ground Roughness | r1 | r2 | r3 | r4 | r5 | r6 |
|---|---|---|---|---|---|---|---|
| Water Region | 0.0001m | 1 | 0 | 0 | 0 | 0 | 0 |
| Arable Land | 0.05m | 0 | 1 | 0 | 0 | 0 | 0 |
| Fields and Paddies | 0.1m | 0 | 0 | 1 | 0 | 0 | 0 |
| Pasture | 0.15m | 0 | 0 | 0 | 1 | 0 | 0 |
| Orchard | 0.2m | 0 | 0 | 0 | 0 | 1 | 0 |
| Forest | 0.5m | 0 | 0 | 0 | 0 | 0 | 1 |
| Downtown Region | 0.8m | 0 | 0 | 0 | 0 | 0 | 0 |

A digital elevation model (DEM) corresponding to a digital data form of the elevation, which is the input variable, that is, a terrain elevation is a model in which a terrain is divided into lattices having a predetermined size and elevation values are recorded, and elevations of each point may be heights measured from a sea level. A spatial resolution of the elevation may be manufactured in 1km×1km, and since it has been known in domestic and foreign studies that the elevation of the terrain has a significant influence on a strength of a wind, many onshore wind power generation farms are positioned at high elevated regions such as Daegwallyeong, Tae Beak, Tae Gi mountain, and the like, in fact in Korea.

The mean elevation may be represented by averaging elevations within a 4×4 lattice in the case in which it is created using 1km elevation data, and

The maximum elevation may be represented by a maximum value among the elevations within the 4×4 lattice in the case in which it is created using the 1km elevation data.

In addition, the minimum elevation may be represented by a minimum value among the elevations within the 4×4 lattice in the case in which it is created using the 1km elevation data.

The relative elevation difference is to compare an elevation of a target region and elevations of surrounding regions with each other to decide whether the correspond region is high or low, and may be built-up in order to consider an influence of a turbulent air and a wind speed increase/decrease that may be generated due to a difference between the elevation of the target region and the elevations of the surrounding regions. In other words, the relative elevation different may be built up by calculating differences between an elevation value of a specific region and elevation values of terrains present in eight directions of the specific region based on the elevation. Providing a description based on geographic information system (GIS) spatial data, a difference between an elevation value of a specific cell and a mean value of elevation values of eight cells adjacent to the specific cell may be calculated. In this case, a positive (+) number means that an elevation of a target region is higher than that of the surrounding region, and a negative (-) number means that the elevation of the target region is lower than that of the surrounding region.

The relative relief, which is one of indices indicating characteristics of a terrain, indicates a difference between the maximum elevation and the minimum elevation. For example, in the case of a mountain region and a land having the same height above sea level, the mountain region has a relative relief larger than that of the land. That is, a magnitude of the relief measured by a predetermined reference, that is, the relative relief may become powerful index in classifying the terrain, establishing a geomorphic province, identifying of a development degree of the terrain, and the like.

The distance from the coast may be represented by calculating linear distances from each of the East Sea, the West Sea, and the South Sea to a central region of the Korean peninsula.

The slope indicates the most rapid descent surface of a target region. In Korean study examples, Han Sun Ho, and the like, (2007) studied on a wind strength change in a mountain range having an asymmetric slope. According to a result of this study, it may be assumed that a slope difference may have an influence on a strength of a wind. Providing a description based on the GIS spatial data, the slope may be calculated as a maximum change rate of elevation values of surrounding cells based on a corresponding cell. That is, a maximum change amount of the elevation depending on distances between a corresponding cell and eight cells adjacent to the corresponding cell is defined as a steep degree of the cell.

The relative slope indicates a difference between a first mean slope of a target region and surrounding and a second mean slope of surrounding regions wider than the first mean slope, and may be built-up in consideration of a slope of the target region and slopes of the surrounding regions enclosing the target region. The reason is that it may be decided that a wind needs to be interpreted within a change of a wide region terrain since the wind continuously flows along a ground and is not rapidly changed spatially. Providing a description based on the GIS spatial data, a difference between a mean slope of a corresponding cell and eight cells adjacent to the corresponding cell and a mean slope of twenty four surrounding cells that are the closet to the corresponding cell may be calculated to build up relative slope data.

The terrain openness, which indicates how much the target region is not topologically closed when the target region and the surrounding regions are compared with each other, is associated with a decrease in a strength of a wind due to collision between the wind and a terrain. In the case of the United States, terrain openness data have been built-up in consideration of the case in which strengths of the wind are different from each other depending on how easily the wind may pass through the terrain of the target region as well as the elevation. For example, in the case in which the terrain is divided into cells having a lattice shape, the terrain openness may be represented by ((central cell + eight surrounding cells) / 9) - ((central cell + twenty four surrounding cells) / 25).

In addition, the terrain openness may be based on the built-up elevation data and be represented by calculating a difference in an elevation value between a specific cell and surrounding cells. In other words, it may be decided that as the value becomes high, the target region has an elevation higher than those of the surrounding regions, such that the terrain openness is high, and as the value becomes low, the target region has an elevation lower than those of the surrounding regions, such that the terrain openness is low.

The wide region terrain openness indicates how much the target region is not topologically closed when the target region is compared with surrounding regions wider than the terrain openness. In other words, the wide region terrain openness may be associated with a decrease in a strength of a wind due to collision between the wind and a terrain by measuring how much the target region is not topologically closed when the target region is compared with the surrounding regions wider than the terrain openness. In the case in which it is assumed that a spatial resolution of the used elevation data is 1km, a terrain feature in a region wider than the region of the terrain openness by 1km may be numerically calculated. For example, in the case in which the terrain is divided into cells having a lattice shape, the wide region terrain openness may be calculated by ((central cell + eight surrounding cells) / 9) - ((central cell + forty eight surrounding cells) / 49). In other words, it may be decided that as the value becomes high, the target region has an elevation higher than those of the surrounding regions, such that the wide region terrain openness is high, and as the value becomes low, the target region has an elevation lower than those of the surrounding regions, such that the wide region terrain openness is low.

The reinterpretation meteorology data correspond to global weather observation data and numerical analysis data re-processed at a spatial resolution of several tens of kilometers or more and distributed for free for a weather forecast, and may be any one selected among NCEP/NCAR (National Center for Environmental Prediction-National Center for Atmospheric Research), MERRA (NASA's Modern-Era Retrospective Analysis for Research and Applications), ECMWF (European Center for Medium-range Weather Forecasts) of Europe, and JRA-25 (The 25-year Japanese ReAnalysis) of Japan. In addition, the reinterpretation meteorology data are a wind power density calculated on a surface layer standard pressure surface except for an influence of the ground, have a unit of $W/m^2$, and are mainly used as input data of a middle scale air flow model numerically analyzing a physical equation for the weather forecast. However, since the reinterpretation meteorology data have a very wide spatial resolution of several tens of kilometers or more and exclude the influence of the ground, it is not appropriate to calculate a wind power density at a selection point only using the reinterpretation meteorology data.

The stepwise regression analyzing step (S2) may include a variable transforming step (S21), a normality deciding step (S22), an output variable inputting step (S23), an input variable inputting step (S24), a stepwise regression analysis multiple performing step (S25), and an optimal stepwise regression analysis data selecting step (S26) .

In the variable transforming step (S21), input variables using nominal variables among the output variable and the input variables input in the variable inputting step (S1) are transformed into dummy variables, one or more of variable transformations of each output variable and input variable for securing normality of the output variable and the input variables is performed, and a variable standardization is performed in order to solve a unit difference between the output variable and the input variables.

Since the regression analysis is created on the assumption of normal distribution, a normalization process needs to be performed through a data transformation process in order to analyze data having a feature of abnormality. Through this process, a distribution of the data having the abnormality may be allowed to be a normal distribution.

For example, for appropriateness for a regression analysis model, a log transformation and a square root transformation may be performed with respect to the wind power density, which is the output variable, and a square root transformation may be performed with respect to the terrain elevation, the slope, the distance from the coast, the maximum elevation, the mean elevation, the minimum elevation, the relative relief, and NCAR/NCEP. The ground roughness of the water region, the arable land, the fields and paddies, the pasture, the orchard, the forest, the downtown region, or the like, and the main direction such as NE_E, E_SE, N_NE, S_SW, or the like, are discontinuous variables. Therefore, in the case in which these variable values are standardized, since there is a difficulty in a statistical analysis, the ground roughnesses and the aspects may be transformed into the dummy variables and be then analyzed. The dummy variable is a variable that becomes 1 in the case in which any condition is satisfied and becomes 0 in other cases.

In the normality deciding step (S22), normality of each of the output variable and the input variables transformed in the variable transforming step (S21) is decided.

In the output variable inputting step (S23), any one selected from the output variable input in the variable inputting step (S10) and the transformed output variable decided to have the normality in the normality deciding step (S22) is input.

In the input variable inputting step (S24), input variables obtained by transforming the input variables using the nominal variables into the dummy variables in the variable transforming step (S21) are input, and any one selected among input variables of the same components of input variables that are not the nominal variables input in the variable inputting step (S10) and the transformed input variables decided to have the normality in the normality deciding step (S22) is input per input variable input in the variable inputting step (S10).

In the stepwise regression analysis multiple performing step (S25), the output variable input in the output variable inputting step (S23) and the input variables input in the input variable inputting step (S24) are received, respectively, and a stepwise regression analysis method is performed once or more.

Here, the regression analysis means a statistical method of recognizing how the output variable is explained and predicted by other several input variables. Generally, the number of input variables that may have an influence on the output variable or may be a cause of the output variable is very large. When a prediction model is created using all possible candidate variables as the input variables, many efforts and costs are required for collecting and managing data, and a problem such as multicollinearity occurs, such that a variance of some of regression coefficient estimates and a variance of a prediction value become very large. Therefore, even though many input variables are used, this model is unreliable.

Therefore, a reduction model including only required variables may be a regression model more preferable than a complete model including unnecessary variables, and an example of a method of selecting these variables includes a forward variable selection method, a backward variable elimination method, and a stepwise variable selection method.

The forward variable selection method is a method of selecting the input variables while adding the input variables one by one depending on a sequence of large contribution levels of each variable with respect to the output variable. This method has an advantage that a calculation time is rapid, but has a disadvantage that variables selected once are never eliminated.

The backward variable elimination method is a method of starting from the complete model including all variables and eliminating input variables having low contribution levels with respect to the output variable one by one. This method may be a comparatively safe method since the possibility that important variables will be excluded is low, but has a disadvantage that variables excluded once may not be again selected.

The stepwise variable selection method is a method in which the forward variable selection method and the backward variable elimination method are combined with each other and is a method of finding out important input variables while repeating selection and elimination in each step. In this method, it may be reviewed in each step whether or not variables that are already selected may be eliminated while additionally selecting important variables one by one.

Generally, the stepwise variable selection method is mainly used, and has, particularly, an advantage that the problem of the multicollinearity is solved.

That is, the important variables are additionally selected one by one, and it is reviewed in each step whether or not variables that are already included in a model may be eliminated. Therefore, in stepwise variable selection, a result may be changed depending on reference of entry and elimination. For example, a preset reference of the stepwise variable selection method may be a p value to be input $\leq 0.10$ and a p value to be eliminated $\geq 0.15$.

The stepwise regression analysis is performed using the selected specific input variables and the output variable, and estimates, standard errors, t values, and significance probability for each regression coefficient, which are resultant values of the stepwise regression analysis, are calculated. The estimates, the standard errors, the t values, the significance probability, and the like, for each regression coefficient are suggested.

In the optimal stepwise regression analysis data selecting step (S26), a stepwise regression analysis result having the highest Coefficient of determination($R^2$) value among resultant values of each stepwise regression analysis derived by performing the stepwise regression analysis multiple performing step (S25) is selected.

The Coefficient of determination($R^2$) indicates how much the sample regression line explains a variation amount of Y, which is the output variable, and may be calculated as a resultant value of SSR/SST (SSR: a sum of square value of a model, and SST: a sum of square value of a corrected total).

The multiple regression equation that may predict an onshore wind power density of a terrain of South Korea may be represented by the following Equation 1.

[Equation 1]

$$\log(\text{wind power density}) = 3.79969 + (0.05551 \times \sqrt{\text{reinterpretation wind power density}}) + (0.04374 \times \sqrt{\text{elevation}}) + (-0.00260 \times \sqrt{\text{distance from coast}}) + (-0.01867 \times \sqrt{\text{minimum elevation}}) + (0.09367 \times \sqrt{\text{slope}}) + (0.00446 \times \text{wide region terrain openness}) + (0.02753 \times \sqrt{\text{mean elevation}}) + (-0.00569 \times \text{terrain openness}) + (0.00075229 \times \text{relative elevation}) + (-0.02608 \times \text{relative slope}) + (0.01661 \times \sqrt{\text{relative relief}}) + (-0.02137 \times \sqrt{\text{maximum elevation}}) + (0.24603 \times r1) + (0.12644 \times r2) + (0.10458 \times r3) + (0.12340 \times r4) + (0.15980 \times r5) + (0.00345 \times r6) + (0.05231 \times a1) + (0.08932 \times a2) + (0.05164 \times a3) + (-0.00168 \times a4) + (-0.03096 \times a5) + (-0.06323 \times a6) + (-0.04673 \times a7)$$

Here, r1 to r6 mean ground roughnesses transformed into dummy variables, and a1 to a7 mean aspects transformed into dummy variables.

Here, an Coefficient of determination($R^2$) value of the multiple regression equation that may predict the onshore wind power density of the terrain of the South Korea may be 0.6267.

Since data of various input variables in addition to the above-mentioned meteorology elements and terrain elements are input to a supercomputer and a numerical analysis is performed on a physical equation of a middle scale air flow model in the multiple regression equation, the multiple regression equation having a reliability of 62.67% with respect to an actual data distribution may be simply and quickly obtained as compared with a method according to the related art in which a wind power density may be predicted using a significant large amount of computing resources and calculating time.

(Second Exemplary Embodiment)

FIG. 2 is a flow chart showing a method for predicting a wind power density according to a second exemplary embodiment of the present invention. Next, the method for predicting a wind power density using a main component analysis technique according to a second exemplary embodiment of the present invention will be described in detail with reference to FIG. 2.

The method for predicting a wind power density using a main component analysis technique according to a second exemplary embodiment of the present invention may include a variable inputting step (S10), a main component analyzing step (S20), a regression analyzing step (S30), and a multiple regression equation estimating step (S40).

In addition, the method for predicting a wind power density using a main component analysis technique according to a second exemplary embodiment of the present invention may be configured in a form of a program that is executed by an execution processing means including a computer.

In the variable inputting step (S10), a wind power density, which is an output variable, and aspects and ground roughnesses transformed into dummy variables may be input. In addition, input variables, which are an elevation, a mean elevation, a maximum elevation, a minimum elevation, a relative elevation, a relative relief, a distance from a coast, a slope, a relative slope, a terrain openness, a wide region terrain openness, which are terrain information, and reinterpretation meteorology data, may be input.

The variables input in the variable inputting step (S10) have the same meaning as that of the variables in the variable inputting step (S10) of the method for predicting a wind power density using a stepwise regression analysis technique according to a first exemplary embodiment of the present invention.

In the main component analyzing step (S20), the input variables input in the variable inputting step (S10) may be analyzed as a plurality of main component input variables through a main component analysis using eigenvalues and cumulative values.

For example, as shown in the following Table 4, the input variables may be analyzed as the plurality of main component input variables using the eigenvalues of the respective input variables.

In the analysis of the main component input variables according to a second exemplary embodiment of the present invention, the input variables may be analyzed as four main component input variables, that is, Prin1, 2, 3, and 4 as shown in the following Table 3. Here, it may be confirmed that Prin1 has a feature of a variable related to the elevation, Prin2 has a feature of a variable related to the terrain openness, Prin3 has a feature of a variable related to the slope and the reinterpretation meteorology data, and Prin4 has a feature of a variable related to the distance from the coast. The four main component input variables are only an example of the present invention.

[Table 3]

| Eigenvalues of the Correlation Matrix | | | | |
|---|---|---|---|---|
| | Eigenvalue | Difference | Proportion | Cumulative |
| 1 | 5.2261 | 2.8132 | 0.4355 | 0.4355 |
| 2 | 2.4129 | 0.8834 | 0.2011 | 0.6366 |
| 3 | 1.5295 | 0.2798 | 0.1275 | 0.7640 |
| 4 | 1.2497 | 0.6988 | 0.1041 | 0.8682 |
| 5 | 0.5508 | 0.0960 | 0.0459 | 0.9141 |
| 6 | 0.4548 | 0.0549 | 0.0379 | 0.9520 |
| 7 | 0.3999 | 0.2743 | 0.0333 | 0.9853 |
| 8 | 0.1257 | 0.0984 | 0.0105 | 0.9958 |
| 9 | 0.0273 | 0.0078 | 0.0023 | 0.9981 |
| 10 | 0.0195 | 0.0157 | 0.0016 | 0.9997 |
| 11 | 0.0038 | 0.0038 | 0.0003 | 1 |
| 12 | 0 | | 0 | 1 |

[Table 4]

| Eigenvectors | | | | | | | | | | | | | |
|---|---|---|---|---|---|---|---|---|---|---|---|---|---|
| | | Prin1 | Prin2 | Prin3 | Prin4 | Prin5 | Prin6 | Prin7 | Prin8 | Prin9 | Prin10 | Prin11 | Prin12 |
| dem | Elevation | 0.4212 | -0.0221 | -0.1312 | -0.1056 | -0.1303 | 0.1085 | 0.0474 | -0.0701 | -0.2518 | -0.8332 | -0.0120 | 0 |
| dem_max | Maximum elevation | 0.4203 | -0.1497 | -0.0395 | -0.0957 | -0.0494 | -0.0757 | 0.340 | 0.1625 | 0.0874 | 0.1895 | 0.3429 | -0.7703 |
| dem_mean | Avarage elevation | 0.4127 | -0.1377 | -0.1200 | -0.1212 | -0.1620 | 0.0981 | 0.0202 | 0.0645 | 0.0452 | 0.2784 | -0.8134 | 0 |
| dem_min | Minimum elevation | 0.3861 | -0.1482 | -0.2004 | -0.1457 | -0.2690 | 0.2834 | 0.0427 | -0.0250 | 0.1264 | 0.2877 | 0.4646 | 0.5457 |
| dem_rehef | Relative relief | 0.3427 | -0.1045 | 0.2392 | 0.0175 | 0.3297 | -0.6458 | 0.0087 | 0.4210 | -0.0050 | -0.0334 | 0.0320 | 0.3298 |
| distance | Distance from coast | 0.1589 | -0.1693 | -0.3501 | 0.4967 | 0.6622 | 0.3469 | -0.1305 | 0.0242 | -0.0134 | 0.0132 | -0.0007 | 0 |
| slope | Slope | 0.3164 | 0.0446 | 0.4587 | 0.2259 | 0.0746 | 0.1232 | 0.0157 | 0.7790 | 0.0305 | 0.0879 | 0.0067 | 0 |
| relative | Terrain openness | 0.1670 | 0.5727 | -0.0816 | 0.0263 | 0.0116 | -0.0208 | -0.3044 | 0.0148 | 0.7187 | -0.1611 | -0.0306 | 0 |
| relative2 | Wide region terrain openness | 0.1846 | 0.5459 | -0.0543 | 0.0288 | -0.0504 | -0.0257 | -0.4576 | 0.0325 | -0.6220 | 0.2467 | 0.0530 | 0 |
| r_slope | Relative slope | 0.0900 | 0.0799 | 0.5947 | 0.4588 | -0.2458 | 0.4182 | 0.0940 | 0.4185 | 0.0029 | -0.0462 | -0.0047 | 0 |
| r_dem | Relative elevation | 0.1144 | 0.5104 | -0.1115 | 0.0027 | 0.1915 | 0.0152 | 0.8109 | 0.0392 0 | -0.0803 | 0.1073 | 0.0008 | 0 |
| NCAR_N CEP | Reinter pretation wind power density | 0.0253 | 0.0422 | 0.4010 | -0.6585 | 0.4790 | 0.4046 | -0.0926 | 0.0369 | -0.0052 | 0.0030 | -0.0005 | 0 |

The regression analyzing step (S30) may include a variable inputting step (S31), a variable transforming step (S32), a normality deciding step (S33), an output variable inputting step (S34), an input variable inputting step (S35), and a regression analysis multiple performing step (S36), as shown in FIG. 3. In the regression analyzing step (S30), the output variable input in the variable inputting step (S10), the input variables input in the variable inputting step (S10) and transformed into the dummy variables, and the main component input variables selected using the main component analysis may be received, and a regression may be performed by a stepwise variable selection method.

In the variable selecting step (S31), one or more main component input variable of which the eigenvalue is a pre-input first predetermined value or more or the cumulative value is smaller than a pre-input second predetermined value among the plurality of main component input variables analyzed in the main component analyzing step (S20) may be selected.

Here, the first predetermined value may be 1, and the second predetermined value may be 0.7 to 0.8.

In the variable transforming step (S32), one or more of variable transformations of the output variables input in the variable inputting step (S10) may be performed in order to secure normality of each of the output variables.

In the normality deciding step (S33), the normality of the output variables transformed in the variable transforming step (S32) may be decided.

In the output variable inputting step (S34), any one selected from the output variable input in the variable inputting step (S10) and the standardized output variable decided to have the normality in the normality deciding step (S33) may be input.

In the input variable inputting step (S35), one or more selected among the input variables configuring the main component input variables selected in the variable selecting step (S31) may be input.

In the regression analysis multiple performing step (S36), the output variable input in the output variable inputting step (S34), the input variable input in the input variable inputting step (S35), and the dummy variables input in the variable inputting step (S10) may be received, respectively, and a regression analysis by a stepwise variable selection method may be performed once or more.

In the multiple regression equation estimating step (S40), a main component multiple regression equation having the highest Coefficient of determination($R^2$) value among the respective regression coefficients calculated by performing the regression analysis multiple performing step (S36) may be selected.

As shown in the following Tables 6 and 7, the Coefficient of determination($R^2$) may indicate how much the sample regression line explains a variation amount of Y, which is the output variable, and may be calculated as a resultant value of SSR/SST (SSR: a sum of square value of a model, and SST: a sum of square value of a corrected total).

Through the regression analysis multiple performing step (S36), estimates, standard errors, t values, and significance probability for each regression coefficient, which are resultant values of the regression analysis by the stepwise variable selection method, may be calculated as shown in the following Table 5. In addition, a general form of the regression analysis may be represented by a function relation of a linear equation, and the main component multiple regression equation depending on the method for predicting a wind power density using a main component analysis technique according to a second exemplary embodiment of the present invention may be represented by the following Equation 2.

[Table 5]

| Regression model estimation | | | | | |
|---|---|---|---|---|---|
| Input variable | Degree of freedom | Regression coefficien t | Standard error | t-value | p-value |
| Intercept | 1 | 4.87579 | 0.01113 | 437.94 | <.0.0001 |
| Prin1 | 1 | 0.11583 | 0.00053544 | 216.32 | <.0.0001 |
| Prin2 | 1 | 0.06275 | 0.00068546 | 91.55 | <.0.0001 |
| Prin3 | 1 | 0.13119 | 0.00089773 | 146.14 | <.0.0001 |
| Prin4 | 1 | -0.17187 | 0.00104 | -165.19 | <.0.0001 |
| r1 | 1 | 0.40142 | 0.01243 | 32.29 | <.0.0001 |
| r2 | 1 | 0.24001 | 0.01094 | 21.95 | <.0.0001 |
| r3 | 1 | 0.20801 | 0.01423 | 14.62 | <.0.0001 |
| r4 | 1 | 0.25655 | 0.01093 | 23.47 | <.0.0001 |
| r5 | 1 | 0.6863 | 0.01159 | 23.1 | <.0.0001 |
| r6 | 1 | 0.08658 | 0.01110 | 7.80 | <.0.0001 |

(continued)

| Regression model estimation | | | | | |
|---|---|---|---|---|---|
| Input variable | Degree of freedom | Regression coefficien t | Standard error | t-value | p-value |
| a1 | 1 | -0.114719 | 0.00462 | -24.74 | <.0.0001 |
| a2 | 1 | -0.05256 | 0.00441 | -11.91 | <.0.0001 |
| a3 | 1 | -0.06328 | 0.00424 | -14.92 | <.0.0001 |
| a4 | 1 | -0.9685 | 0.00432 | -22.43 | <.0.0001 |
| a5 | 1 | -0.10314 | 0.00436 | -23.68 | <.0.0001 |
| a6 | 1 | -0.11079 | 0.00420 | -26.37 | <.0.0001 |
| a7 | 1 | -0.06658 | 0.00415 | -16.04 | <.0.0001 |

[Table 6]

| Variance analysis | | | | | |
|---|---|---|---|---|---|
| Factor | Degree of freedom | Sum of squares | Mean square | F-ratio | p-value |
| Regression | 17 | 11949 | 702.87000 | 7229.05 | <.0.0001 |
| Error | 87631 | 8520.22877 | 0.09723 | | |
| Total | 87648 | 20469 | | | |

[Table 7]

| | | | |
|---|---|---|---|
| Square root of mean square error | 0.31181 | R-square | 0.5838 |
| Mean of output variables | 5.01893 | Adjusted R-square | 0.5837 |
| Coefficient of variation | 6.21278 | | |

[Equation 2]

log(wind power density) = 4.87579 + (0.11583 × first main component input variable) + (0.06275 × second main component input variable) + (0.13119 × third main component input variable) + (-0.17187 × fourth main component input variable) + (0.40142 × r1) + (0.24001 × r2) + (0.20801 × r3) + (0.25655 × r4) + (0.26863 × r5) + (0.08658 × r6) + (-0.11419 × a1) + (-0.05256 × a2) + (-0.06328 × a3) + (-0.09685 × a4) + (-0.10314 × a5) + (-0.11079 × a6) + (-0.06658 × a7)

Here, r1 to r6 mean ground roughnesses transformed into dummy variables, and

a1 to a7 mean aspects transformed into dummy variables.

Therefore, an Coefficient of determination($R^2$) value of the main component multiple regression equation that may predict the onshore wind power density of the terrain of the South Korea may be 0.5838.

Since data of various input variables in addition to the above-mentioned meteorology elements and terrain elements are input to a supercomputer and a numerical analysis is performed on a physical equation of a middle scale air flow model in the main component multiple regression equation, the main component multiple regression equation having a reliability of 58.38% with respect to an actual data distribution may be simply and quickly obtained as compared with a method according to the related art in which a wind power density may be predicted using a significant large amount of computing resources and calculating time.

In other words, in the case of executing the regression analysis depending on the method for predicting a wind power density using a main component analysis technique according to a second exemplary embodiment of the present invention, the output variable log-transformed in the variable transforming step (S32), the four main component input variables selected by analyzing main components of the input variables in the variable selecting step (S31), and thirteen dummy variables through the aspect and the ground roughness may be used. In addition, variables eliminated at the time of performing the analysis are not present, Prin1, which is the variable related to the elevation, has the largest influence on the wind power density, and Prin4, which is the variable related to the distance from the coast, Prin3, which is the variable related to the slope and the reinterpretation meteorology data, a ground roughness 0.15, and a ground roughness 0.05 may sequentially have influences on the wind power density. Therefore, in the case in which the Coefficient of determination($R^2$) value of the main component multiple regression equation is 0.5838, the regression analysis may be optimal.

(Third Exemplary Embodiment)

Generally, a study on a neural network or an artificial neural network has started by having inspiration from neurophysiology. A data analysis using a neural network analysis may be classified as one of flexible non-linear models used in order to predict a resultant value in data having a complicated structure. The neural network is distinguished from a general statistical model by unique components called hidden units. The respective hidden units, which model neurons of a human being, may receive a combination of input variables and transfer the combination of the input variables to a target variable. As the neural network, there are various models. Among them, a multilayer perceptron (MLP) neural network model is most widely used in order to analyze data.

The MLP neural network model is configured of an input layer, a hidden layer, and an output layer, wherein the hidden layer includes nodes called hidden nodes. In addition, in a feed-forward neural network that is most used among the MLP neural networks, a node of one layer is connected only to a node of the next layer, and is not connected in an opposite direction.

In a method for predicting a wind power density using a neural network analysis technique according to an exemplary embodiment of the present invention, a neural network analysis model using the MLP neural network, having a small number of hidden nodes, and having a significantly decreased root mean square error (RMSE) value is estimated. In addition, a neural network model in which a coefficient of correlation between output variable values estimated from each model and actual output variable values is highest among several neural network models built-up through various variable transformations of input variables and output variables is determined as a final neural network model for predicting the wind power density.

FIG. 4 is a flow chart showing a method for predicting a wind power density according to a third exemplary embodiment of the present invention. Next, the method for predicting a wind power density using a neural network analysis technique according to a third exemplary embodiment of the present invention will be described in detail with reference to FIG. 4.

The method for predicting a wind power density using a neural network analysis technique according to a third exemplary embodiment of the present invention may include a variable inputting step (S100), a neural network analyzing step (S200), and a neural network model estimating step (S300).

In addition, the method for predicting a wind power density using a neural network analysis technique according to a third exemplary embodiment of the present invention may be configured in a form of a program that is executed by an execution processing means including a computer.

In the variable inputting step (S100), an output variable and input variables from which terrain information is selected are input.

Here, the output variable means a wind power density, a national wind map having a spatial resolution of 1km×1km, built-up by Korean Institute of Energy Research may be used as numerical wind data of the wind power density, and the wind power density may be used as the output variable. In addition, the meaning that the wind power density is high is that wind power is high, and $W/m^2$ may be used as a unit of the wind power density.

The input variables mean any one selected among first terrain information including an aspect and a ground roughness transformed into dummy variables, second terrain information including an elevation (DEM) and a relative elevation difference (r_DEM), a third terrain information including a terrain openness (relative) and a wide region terrain openness (relative2), fourth terrain information including a slope and a relative slope (r-slope), fifth terrain information including a minimum elevation (DEM_min), a maximum elevation (DEM_max), and a mean elevation (DEM_mean), a relative relief, a distance from a coast, and reinterpretation meteorology data (NCAR_NCEP).

Input variable selection methods in first to third exemplary embodiments are stepwise variable selection methods that are the same as each other.

In the neural network analyzing step (S200), a neural network analysis is performed using the output variable input in the variable inputting step (S100) and the input variables selected through a stepwise variable selection method.

Here, the stepwise variable selection method is a method in which the forward variable selection method and the backward variable elimination method are combined with each other and is a method of finding out important input variables while repeating selection and elimination in each step. In other words, the stepwise variable selection method is a method of reviewing, in each step, whether or not input variables that are already selected may be eliminated while additionally selecting important input variables one by one. Generally, the stepwise variable selection method is mainly used, and has, particularly, an advantage that the problem of the multicollinearity is solved.

That is, in the stepwise variable selection method, it is reviewed in each step whether or not the input variables that have already entered a model may be eliminated while additionally selecting the important input variables one by one, such that a result may be changed depending on references of entry and elimination in stepwise variable selection. For example, a preset reference of the stepwise input variable selection method may be a p value to enter $\leq 0.10$ and a p value to be eliminated $\geq 0.15$.

In addition, the neural network analysis may be configured an input layer X, a hidden layer H, and an output layer Y, as shown in FIG. 5, and the neural network analysis model through the neural network analyzing step (S200) may be a neural network model having three hidden units in one hidden layer, which is only an example.

In the neural network model according to an exemplary embodiment of the present invention, each input variable, that is, the output variable and the input variables input in the variable inputting step (S100) are standardized and transferred to the input layer, and the standardized variables are combined with a hyperbolic tangent function and are transferred to the hidden layer.

The hidden layer processes a linear combination of the variable values transferred from the input layer as a non-linear function and transfers the processed linear combination to the output layer, and the output layer transfers an output value corresponding to a target variable.

Here, variable values of the hidden layer and the output layer of FIG. 5 may be represented by the following Equation 3.

[Equation 3]

$$H_1 = f_1(b_1 + w_{11}X_1 + w_{21}X_2 + \cdots + w_{p1}X_p)$$
$$H_2 = f_2(b_2 + w_{12}X_1 + w_{22}X_2 + \cdots + w_{p2}X_p)$$
$$H_3 = f_3(b_3 + w_{13}X_1 + w_{23}X_2 + \cdots + w_{p3}X_p)$$
$$H_4 = f_4(b_4 + w_{14}X_1 + w_{24}X_2 + \cdots + w_{p4}X_p)$$
$$Y = g(b_0 + w_{10}H_1 + w_{20}H_2 + w_{30}H_3 + w_{40}H_4)$$

The neural network analyzing step (S200) may include a first analyzing step (S210), a second analyzing step (S220), a third analyzing step (S230), a fourth analyzing step (S240), and a fifth analyzing step (S250), and root mean square error (RMSE) values and the numbers of hidden nodes for each neural network model are calculated through the first to fifth analyzing steps (S210 to S250).

Here, the RMSE value is a value indicating a difference between an observed value and a predicted value. It may be considered that the smaller the RMSE value, the more appropriate the neural network model. That is, it may be considered that the smaller the number of hidden nodes and the smaller the RMSE value, the better the neural network model.

In the first analyzing step (S210), in order to predict the wind power density, the output variable is transformed into a log(wind power density) form, that is, the wind power density is log-transformed, normalized, and used, and the neural network analysis is performed on thirteen dummy variables of the aspect and the ground roughness transformed into the dummy variables and twelve input variables using the stepwise variable selection method. Here, the maximum elevation and the relative relief among the input variables used for the neural network analysis may be excluded depending on a result of the stepwise variable selection method. The number of hidden nodes when the calculated RMSE value is small may be confirmed through the first analyzing step (S210). Therefore, it is revealed that three hidden nodes are most appropriate as a result of the neural network analysis by the first analyzing step (S210).

In the second analyzing step (S220), in order to predict the wind power density, the output variable is used in an original variable form as it is, and the neural network analysis is performed on thirteen dummy variables of the aspect and the ground roughness transformed into the dummy variables and twelve input variables using the stepwise variable selection method. Here, the relative relief among the input variables used for the neural network analysis may be excluded depending on a result of the stepwise variable selection method. The number of hidden nodes when the calculated RMSE value is small may be confirmed through the second analyzing step (S220). Therefore, it is revealed that three hidden nodes are most appropriate as a result of the neural network analysis by the second analyzing step (S220).

In the third analyzing step (S230), in order to predict the wind power density, the output variable is transformed into a sqrt(wind power density) form, that is, the wind power density is square-root-transformed, normalized, and used, and the neural network analysis is performed on thirteen dummy variables of the aspect and the ground roughness transformed into the dummy variables and twelve input variables using the stepwise variable selection method. Here, the maximum elevation among the input variables used for the neural network analysis may be excluded depending on a result of the stepwise variable selection method. The number of hidden nodes when the calculated RMSE value is small may be confirmed through the third analyzing step (S230). Therefore, it is revealed that three hidden nodes are most appropriate as a result of the neural network analysis by the third analyzing step (S230).

In the fourth analyzing step (S240), in order to predict the wind power density, the output variable is transformed into a log(wind power density) form, that is, the wind power density is log-transformed, normalized, and used, and the neural network analysis is performed on thirteen dummy variables of the aspect and the ground roughness transformed into the dummy variables and twelve input variables using the stepwise variable selection method. Here, eight input variables, that is, the elevation, the slope, the distance from the coast, the maximum elevation, the mean elevation, the minimum elevation, the relative relief, and the reinterpretation meteorology data, that do not satisfy the normality among the twelve input variables are square-root-transformed. The number of hidden nodes when the calculated RMSE value is small may be confirmed through the fourth analyzing step (S240). Therefore, it is revealed that three hidden nodes are most appropriate as a result of the neural network analysis by the fourth analyzing step (S240). Here, log(wind power density) means a value obtained by log-transforming the wind power density.

In the fifth analyzing step (S250), in order to predict the wind power density, the output variable is transformed into a sqrt(wind power density) form, that is, the wind power density is square-root-transformed, normalized, and used, and the neural network analysis is performed on thirteen dummy variables of the aspect and the ground roughness transformed into the dummy variables and twelve input variables using the stepwise variable selection method. Here, eight input variables, that is, the elevation, the slope, the distance from the coast, the maximum elevation, the mean elevation, the minimum elevation, the relative relief, and the reinterpretation meteorology data, that do not satisfy the normality among the twelve input variables are square-root-transformed. The number of hidden nodes when the calculated RMSE value is small may be confirmed through the fifth analyzing step (S250). Therefore, it is revealed that four hidden nodes are most appropriate as a result of the neural network analysis by the fifth analyzing step (S250).

In summary, as shown in the following Table 8, it may be confirmed that the numbers of hidden nodes are different from each other depending on the used output variable, input variables, and dummy variables.

[Table 8]

| Sequen ce | Variable form | Number of hidden nodes |
|---|---|---|
| S210 | log(output variable) + dummy variable + input variable | Three |
| S220 | output variable + dummy variable + input variable | Three |
| S230 | sqrt(output variable) + dummy variable + input variable | Three |
| S240 | log(output variable) + dummy variable + sqrt(input variable) | Three |

(continued)

| Sequen ce | Variable form | Number of hidden nodes |
|---|---|---|
| S250 | sqrt(output variable) + dummy variable + sqrt(input variable) | Four |

In the neural network model estimating step (S300), a neural network analysis model in which the number of hidden nodes is significantly decreased may be estimated using an RMSE value calculated through the neural network analyzing step (S200), that is, the first to fifth analyzing steps (S210 to S250). In addition, a neural network model in which a coefficient of correlation between output variable values estimated from each of several neural network models estimated through various variable transformations of the input variables and the output variable and actual output variable values is highest is determined as a final neural network model for predicting the wind power density.

The coefficient of correlation, which is a value indicating a correlation between an actually observed output variable value and a predicted output variable value, has a value between -1 and 1. The closer to 1 the coefficient of correlation, the more appropriate the model. The following Table 9 shows values of coefficient of correlations calculated by the method for predicting a wind power density using a neural network analysis technique according to a third exemplary embodiment of the present invention.

[Table 9]

| Sequen ce | Variable form | Coefficie nt of correlati on | Number of hidden nodes |
|---|---|---|---|
| S210 | log(output variable) + dummy variable + input variable | 0.8438 | Three |
| S220 | output variable + dummy variable + input variable | 0.8398 | Three |
| S230 | sqrt(output variable) + dummy variable + input variable | 0.8502 | Three |
| S240 | log(output variable) + dummy variable + sqrt (input variable) | 0.8267 | Three |
| S250 | sqrt(output variable) + dummy variable + sqrt (input variable) | 0.8481 | Four |

In other words, it may be appreciated that the best neural analysis model having the most excellent predictability estimated through the method for predicting a wind power density using a neural network analysis technique according to a third exemplary embodiment of the present invention is a neural analysis model having the three hidden nodes except for the maximum elevation variable by transforming the output variable that may be estimated through the third analyzing step (S230) in the sqrt(wind power density) form, normalizing the transformed output variable, and using the stepwise variable selection method on the thirteen dummy variables of the aspect and the ground roughness transformed into the dummy variables and the twelve input variables, as shown in the above Table 8.

Hereinabove, although the present invention has been described by specific matters such as detailed components, exemplary embodiments, and the accompanying drawings, they have been provided only for assisting in the entire understanding of the present invention. Therefore, the present invention is not limited to the exemplary embodiments. Various modifications and changes may be made by those skilled in the art to which the present invention pertains from this description.

[Detailed Description of Main Elements]

S1 to S3: Method for predicting wind power density using stepwise regression analysis technique according to the present invention

S10 to S40: Method for predicting wind power density using main component analysis technique according to the present invention

S100 to S300: Method for predicting wind power density using neural network analysis technique according to the present invention

## Claims

1. A method for predicting a wind power density using a stepwise regression analysis technique, configured in a form of a program executed by an execution processing means including a computer, comprising:

   a variable inputting step (S1) of inputting the wind power density, which is an output variable, and two or more input variables selected among ground roughnesses (r1 to r6), an elevation, a relative elevation difference, a terrain openness, a wide region terrain openness, aspects (a1 to a7), a slope, a relative slope, a mean elevation, a maximum elevation, a minimum elevation, a relative relief, a distance from a coast, and reinterpretation meteorology data;
   a stepwise regression analyzing step (S2) of receiving the output variable and the input variables input in the variable inputting step (S1) and performing a regression analysis method by a stepwise variable selection method; and
   a multiple regression equation estimating step (S3) of estimating a multiple regression equation having the highest Coefficient of determination($R^2$) value using regression coefficients calculated in the stepwise regression analyzing step (S2),
   wherein the stepwise regression analyzing step (S2) further comprises a variable transforming step (S21) of transforming the input variables using nominal variables among the output variable and the input variables input in the variable inputting step (S1) into dummy variables, while using each of the output variable and the input variables in an original variable form or performing a variable transformation of each of the output variable and the input variables, the variable transformation being a log transformation or a square root transformation.

2. The method for predicting a wind power density of claim 1, wherein the ground roughnesses (r1 to r6) indicate types of grounds depending on utilization of a land,
   the aspects (a1 to a7) indicate directions of inclined surfaces,
   the elevation (DEM) indicates an elevation value of a lattice divided from a terrain and having a predetermined size,
   the relative elevation difference indicates a comparison value between an elevation of a target region and elevations of surrounding regions,
   the mean elevation indicates a mean of elevations of the target region,
   the maximum elevation indicates a maximum value of the elevations of the target region,
   the minimum elevation indicates a minimum value of the elevations of the target region,
   the relative relief indicates a difference between the maximum elevation and the minimum elevation,
   the terrain openness indicates a value obtained by measuring how much the target region is not topologically closed when the target region and the surrounding regions are compared with each other,
   the wide region terrain openness indicates a value obtained by measuring how much the target region is not topologically closed when the target region is compared with surrounding regions wider than the surrounding regions of the terrain openness,
   the slope indicates the most rapid descent surface of the target region,
   the relative slope indicates a difference between a first mean slope of the target region and the surrounding regions and a second mean slope of surrounding regions wider than the surrounding regions of the first mean slope,
   the distance from the coast indicates linear distances from an east coast, a west coast, a south coast or a north coast to the target region, and
   the reinterpretation meteorology data correspond to global weather observation data and numerical analysis data re-processed at a spatial resolution of several tens of kilometers or more and distributed for free for a weather forecast, and is any one selected among NCEP/NCAR (National Center for Environmental Prediction-National Center for Atmospheric Research), MERRA (NASA's Modern-Era Retrospective Analysis for Research and Applications), ECMWF (European Center for Medium-range Weather Forecasts) of Europe, and JRA-25 (The 25-year Japanese ReAnalysis) of Japan.

3. The method for predicting a wind power density of claim 1, wherein the stepwise regression analyzing step (S2) includes:

   a normality deciding step (S22) of deciding normality of each of the output variable and the input variables transformed in the variable transforming step (S21);
   an output variable inputting step (S23) of inputting any one selected from the output variable input in the variable inputting step (S1) and the transformed output variable decided to have the normality in the normality deciding step (S22);
   an input variable inputting step (S24) of inputting input variables obtained by transforming input variables using nominal variables into dummy variables in the variable transforming step (S21) and inputting any one selected among input variables of the same components of input variables that are not the nominal variables input in the variable inputting step (S1) and the transformed input variables decided to have the normality in the normality deciding step (S22) per input variable input in the variable inputting step (S1);
a stepwise regression analysis multiple performing step (S25) of receiving the output variable input in the output variable inputting step (S23) and the input variables input in the input variable inputting step (S24), respectively, and performing the regression analysis method by the stepwise variable selection method once or more; and
an optimal stepwise regression analysis data selecting step (S26) of selecting a regression analysis result by the stepwise variable selection method having the highest Coefficient of determination($R^2$) value among resultant values of each stepwise regression analysis derived by performing the stepwise regression analysis multiple performing step (S25).

**4.** The method for predicting a wind power density of claim 1, wherein the multiple regression equation predicting an onshore wind power density is

$$\log(\text{wind power density}) = 3.79969 + (0.05551 \times \sqrt{\text{reinterpretation wind power density}}) + (0.04374 \times \sqrt{\text{elevation}}) + (-0.00260 \times \sqrt{\text{distance from coast}}) + (-0.01867 \times \sqrt{\text{minimum elevation}}) + (0.09367 \times \sqrt{\text{slope}}) + (0.00446 \times \text{wide region terrain openness}) + (0.02753 \times \sqrt{\text{mean elevation}}) + (-0.00569 \times \text{terrain openness}) + (0.00075229 \times \text{relative elevation}) + (-0.02608 \times \text{relative slope}) + (0.01661 \times \sqrt{\text{relative relief}}) + (-0.02137 \times \sqrt{\text{maximum elevation}}) + (0.24603 \times r1) + (0.12644 \times r2) + (0.10458 \times r3) + (0.12340 \times r4) + (0.15980 \times r5) + (0.00345 \times r6) + (0.05231 \times a1) + (0.08932 \times a2) + (0.05164 \times a3) + (-0.00168 \times a4) + (-0.03096 \times a5) + (-0.06323 \times a6) + (-0.04673 \times a7),$$

where r1 to r6 are dummy variables of the ground roughnesses and a1 to a7 are dummy variables of the aspects, wherein an Coefficient of determination($R^2$) value of the multiple regression equation predicting the onshore wind power density of the terrain of the South Korea is 0.6267.

**5.** A method for predicting a wind power density using a main component analysis technique, configured in a form of a program executed by an execution processing means including a computer, comprising:

a variable inputting step (S10) of inputting the wind power density, which is an output variable, dummy variables, which are aspects (a1 to a7) and ground roughnesses (r1 to r6), and two or more input variables selected among an elevation, a relative elevation difference, a terrain openness, a wide region terrain openness, a slope, a relative slope, a mean elevation, a maximum elevation, a minimum elevation, a relative relief, a distance from a coast, and reinterpretation meteorology data;
a main component analyzing step (S20) of analyzing the input variables input in the variable inputting step (S10) as a plurality of main components through a main component analysis using eigenvalues and cumulative values;
a regression analyzing step (S30) of performing a regression analysis by a stepwise variable selection method using the output variable and the dummy variables input in the variable inputting step (S10) and the input variables analyzed as the plurality of main components in the main component analyzing step (S20); and

a multiple regression equation estimating step (S40) of estimating a multiple regression equation having the highest Coefficient of determination ($R^2$) value using regression coefficients calculated in the regression analyzing step (S30),
wherein regression analyzing step (S30) further comprises a variable transforming step (S32) of performing a variable transformation of the output variable input in the variable inputting step (S10), the variable transformation being a log transformation or a square root transformation.

6. The method for predicting a wind power density of claim 5, wherein
the ground roughnesses (r1 to r6) indicate types of grounds depending on utilization of a land,
the aspects (a1 to a7) indicate directions of inclined surfaces,
the elevation (DEM) indicates an elevation value of a lattice divided from a terrain and having a predetermined size,
the relative elevation difference indicates a comparison value between an elevation of a target region and elevations of surrounding regions,
the mean elevation indicates a mean of elevations of the target region,
the maximum elevation indicates a maximum value of the elevations of the target region,
the minimum elevation indicates a minimum value of the elevations of the target region,
the relative relief indicates a difference between the maximum elevation and the minimum elevation,
the terrain openness indicates a value obtained by measuring how much the target region is not topologically closed when the target region and the surrounding regions are compared with each other,
the wide region terrain openness indicates a value obtained by measuring how much the target region is not topologically closed when the target region is compared with surrounding regions wider than the surrounding regions of the terrain openness,
the slope indicates the most rapid descent surface of the target region,
the relative slope indicates a difference between a first mean slope of the target region and the surrounding regions and a second mean slope of surrounding regions wider than the surrounding regions of the first mean slope,
the distance from the coast indicates linear distances from an east coast, a west coast, a south coast or a north coast to the target region, and
the reinterpretation meteorology data correspond to global weather observation data and numerical analysis data re-processed at a spatial resolution of several tens of kilometers or more and distributed for free for a weather forecast, and is any one selected among NCEP/NCAR (National Center for Environmental Prediction-National Center for Atmospheric Research), MERRA (NASA's Modern-Era Retrospective Analysis for Research and Applications), ECMWF (European Center for Medium-range Weather Forecasts) of Europe, and JRA-25 (The 25-year Japanese ReAnalysis) of Japan.

7. The method for predicting a wind power density of claim 5, wherein the regression analyzing step (S30) includes:

a variable selecting step (S31) of selecting one or more main component of which the eigenvalue is a pre-input first predetermined value or more or the cumulative value is smaller than a pre-input second predetermined value among the plurality of main components analyzed in the main component analyzing step (S20);
a normality deciding step (S33) of deciding normality of the output variable transformed in the variable transforming step (S32);
an output variable inputting step (S34) of inputting any one selected from the output variable input in the variable inputting step (S10) and the standardized output variable decided to have the normality in the normality deciding step (S33);
an input variable inputting step (S35) of inputting one or more selected among the input variables configuring the main components selected in the variable selecting step (S31); and
a regression analysis multiple performing step (S36) of receiving the output variable input in the output variable inputting step (S34), the input variable input in the input variable inputting step (S35), and the dummy variables input in the variable inputting step (S10), respectively, and performing the regression analysis by the stepwise variable selection method once or more,.

8. The method for predicting a wind power density of claim 5, wherein the main component multiple regression equation predicting an onshore wind power density is log(wind power density) = 4.87579 + (0.11583 × first main component input variable) + (0.06275 × second main component input variable) + (0.13119 × third main component input variable) + (-0.17187 × fourth main component input variable) + (0.40142 × r1) + (0.24001 × r2) + (0.20801 × r3) + (0.25655 × r4) + (0.26863 × r5) + (0.08658 × r6) + (-0.11419 × a1) + (-0.05256 × a2) + (-0.06328 × a3) + (-0.09685 × a4) + (-0.10314 × a5) + (-0.11079 × a6) + (-0.06658 × a7),
where r1 to r6 are dummy variables of the ground roughnesses and a1 to a7 are dummy variables of the aspects, wherein an Coefficient of determination($R^2$) value of the main component regression equation predicting the onshore wind power density of the terrain of the South Korea is 0.5838.

**9.** A method for predicting a wind power density using a neural network analysis technique, configured in a form of a program executed by an execution processing means including a computer, comprising:

a variable inputting step (S100) of inputting the wind power density, which is an output variable, and two or more input variables selected among ground roughnesses (r1 to r6), an elevation, a relative elevation difference, a terrain openness, a wide region terrain openness, aspects (a1 to a7), a slope, a relative slope, a mean elevation, a maximum elevation, a minimum elevation, a relative relief, a distance from a coast, and reinterpretation meteorology data;
a neural network analyzing step (S200) of performing a neural network analysis using the output variable input in the variable inputting step (S100) and the input variables selected through a stepwise variable selection method; and
a neural network model estimating step (S300) of estimating a neural network analysis model through a coefficient of correlation value using a number of hidden nodes depending on a root mean square error (RMSE) value calculated in the neural network analyzing step (S200),
wherein in the neural network analyzing step (S200), the output variable input in the variable inputting step (S100) is used in an original variable form or a variable transformation of the output variable input in the variable inputting step (S100) is performed, the variable transformation being a log transformation or a square root transformation.

**10.** The method for predicting a wind power density of claim 9, wherein the ground roughnesses (r1 to r6) of the variable inputting step (S100) indicate types of grounds depending on utilization of a land,
the aspects (a1 to a7) indicate directions of inclined surfaces, and
the ground roughnesses and the aspects are transformed into dummy variables.

**11.** The method for predicting a wind power density of claim 9, wherein the neural network analyzing step (S200) includes a first analyzing step (S210) of performing the neural network analysis using the output variable log-transformed and the input variable using the stepwise variable selection method.

**12.** The method for predicting a wind power density of claim 9, wherein the neural network analyzing step (S200) includes a second analyzing step (S220) of performing the neural network analysis using the output variable in an original data form and the input variable using the stepwise variable selection method.

**13.** The method for predicting a wind power density of claim 9, wherein the neural network analyzing step (S200) includes a third analyzing step (S230) of performing the neural network analysis using the output variable square-root-transformed and the input variable using the stepwise variable selection method.

**14.** The method for predicting a wind power density of claim 9, wherein the neural network analyzing step (S200) includes a fourth analyzing step (S240) of performing the neural network analysis using the output variable log-transformed and the input variable using the stepwise variable selection method, and
the elevation, the slope, the distance from the coast, the maximum elevation, the mean elevation, the minimum elevation, the relative relief, and the reinterpretation meteorology data are square-root-transformed.

**15.** The method for predicting a wind power density of claim 9, wherein the neural network analyzing step (S200) includes a fifth analyzing step (S250) of performing the neural network analysis using the output variable square-root-transformed and the input variable using the stepwise variable selection method, and
the elevation, the slope, the distance from the coast, the maximum elevation, the mean elevation, the minimum elevation, the relative relief, and the reinterpretation meteorology data are square-root-transformed.

## Patentansprüche

**1.** Verfahren zum Vorhersagen einer Windenergiedichte unter Verwendung einer schrittweisen Regressionsanalysetechnik, die in Form eines Programms ausgebildet ist, das von einem Ausführungsverarbeitungsmittel einschließlich eines Computers ausgeführt wird, umfassend:

einen Schritt (S1) zur Eingabe einer Variablen zur Eingabe der Windenergiedichte, die eine Ausgabevariable ist, und von zwei oder mehr Eingabevariablen, ausgewählt aus Bodenrauhigkeiten (r1 bis r6), einer Höhe, einem relativen Höhenunterschied, einer Geländeoffenheit, einer Geländeoffenheit im Weitbereich, Aspekten (a1 bis a7), einer Neigung, einer relativen Neigung, einer mittleren Höhe, einer maximalen Höhe, einer minimalen Höhe, einem relativen Relief, einer Entfernung von einer Küste und reinterpretierten Meteorologiedaten;
einen schrittweisen Regressionsanalyseschritt (S2) zum Empfangen der Ausgabevariablen und der in dem Schritt (S1) zur Eingabe einer Variablen eingegebenen Eingabevariablen und Ausführen eines Regressionsanalyseverfahrens durch ein schrittweises Variablenauswahlverfahren; und
einen multiplen Regressionsgleichungsschätzungsschritt (S3) zum Schätzen einer multiplen Regressionsgleichung mit dem höchsten Bestimmungskoeffizient ($R^2$) Wert unter Verwendung von Regressionskoeffizienten, die in dem schrittweisen Regressionsanalyseschritt (S2) berechnet wurden,
wobei der schrittweise Regressionsanalyseschritt (S2) ferner einen Schritt (S21) zur Variablentransformation zum Transformieren der Eingabevariablen unter Verwendung von Nominalvariablen unter den Ausgabevariablen und den im Schritt (S1) zur Eingabe einer Variablen eingegebenen Eingabevariablen in Dummy-Variablen umfasst, während jede der Ausgabevariablen und der Eingabevariablen in einer Form der ursprünglichen Variablen verwendet wird oder eine Variablentransformation jeder der Ausgabevariablen und der Eingabevariablen durchgeführt wird, wobei die Variablentransformation eine Log-Transformation oder eine Quadratwurzeltransformation ist.

**2.** Verfahren zum Vorhersagen einer Windenergiedichte nach Anspruch 1, wobei die Bodenrauhigkeiten (r1 bis r6) Typen von Böden in Abhängigkeit von der Nutzung eines Gebietes angeben,
die Aspekte (a1 bis a7) Richtungen von geneigten Oberflächen angeben,
die Höhe (DEM) einen Höhenwert eines Gitters angibt, das von einem Gelände getrennt ist und eine vorbestimmte Größe aufweist,
die relative Höhendifferenz einen Vergleichswert zwischen einer Höhe einer Zielregion und Höhen der umliegenden Regionen angibt,
die mittlere Höhe einen Mittelwert der Höhen der Zielregion angibt,
die maximale Höhe einen Maximalwert der Höhen der Zielregion angibt,
die minimale Höhe einen Mindestwert der Höhen der Zielregion angibt,
das relative Relief eine Differenz zwischen der maximalen Höhe und der minimalen Höhe angibt,
die Geländeoffenheit einen Wert angibt, der durch Messen erhalten wird, wie viel die Zielregion nicht topologisch geschlossen ist, wenn die Zielregion und die umliegenden Regionen miteinander verglichen werden,
die Geländeoffenheit im Weitbereich einen Wert angibt, der durch Messen erhalten wird, wie viel die Zielregion nicht topologisch geschlossen ist, wenn die Zielregion mit umliegenden Regionen verglichen wird, die größer sind als die umliegenden Regionen der Geländeoffenheit,
die Neigung die schnellste Gefällefläche der Zielregion angibt,
die relative Neigung einen Unterschied zwischen einer ersten mittleren Neigung der Zielregion und der umliegenden Regionen und einer zweiten mittleren Neigung der umliegenden Regionen angibt, die größer sind als die umliegenden Regionen der ersten mittleren Neigung,
die Entfernung von der Küste lineare Entfernungen von einer Ostküste, einer Westküste, einer Südküste oder einer Nordküste zur Zielregion angibt, und
die reinterpretierten Meteorologiedaten globalen Wetterbeobachtungsdaten und numerischen Analysedaten entsprechen, die in einer räumlichen Auflösung von mehreren zehn Kilometern oder mehr neu verarbeitet und für eine Wettervorhersage kostenlos bereitgestellt werden und ausgewählt sind aus NCEP/NCAR (Nationales Zentrum für Umweltvorhersage - Nationales Zentrum für Atmosphärenforschung), MERRA (NASAs moderne retrospektive Analyse für Forschung und Anwendungen), ECMWF (Europäisches Zentrum für mittelfristige Wettervorhersagen für Europa) und JRA-25 (die 25-Jahre japanische Re-Analyse) für Japan.

**3.** Verfahren zum Vorhersagen einer Windenergiedichte nach Anspruch 1, wobei der schrittweise Regressionsanalyseschritt (S2) umfasst:

einen Normalitätsentscheidungsschritt (S22) zum Bestimmen der Normalität jeder der Ausgabevariablen und der in dem Variablentransformationsschritt (S21) transformierten Eingangsvariablen;
einen Ausgabevariableneingabeschritt (S23) zum Eingeben einer Variablen, die ausgewählt ist aus den Ausgabevariablen, die in dem Schritt (S1) zur Eingabe einer Variablen eingegeben wurden, und transformierten Ausgabevariablen, die im Normalitätentscheidungsschritt (S22)bestimmt wurden, Normalität aufzuweisen;
einen Eingabeschritt (S24) für Eingabevariablen zum Eingeben von Eingabevariablen, die durch Transformieren von Eingabevariablen unter Verwendung von Nominalvariablen in Dummy-Variablen im Variablentransformationsschritt (S21) erhalten wurden und Eingeben einer aus Eingabevariablen derselben Komponenten von Eingabevariablen ausgewählten Variablen, die nicht die im Schritt (S1) zur Eingabe einer Variablen eingegebenen Nominalvariablen sind, und der transformierten Eingabevariablen, die bestimmt wurden, die Normalität im Normalitätentscheidungsschritt (S22) pro Eingabevariabler, die im Schritt (S1) zur Eingabe einer Variablen eingegeben wurde, aufzuweisen;
einen schrittweisen Regressionsanalyse-Mehrfachdurchführungsschritt (S25) zum jeweiligen Empfangen der Ausgangsvariablen, die in dem
Ausgangsvariableneingabeschritt (S23) eingegeben wurden und der Eingabevariablen, die in dem Eingabevariableneingabeschritt (S24) eingegeben wurden,
und einmaliges oder mehrmaliges Durchführen des Regressionsanalyseverfahrens durch das schrittweisen Variablenauswahlverfahren; und
einen optimalen schrittweisen Regressionsanalysedatenauswahlschritt (S26) zum Auswählen eines Regressionsanalyse-Ergebnisses durch das schrittweise Variablenauswahlverfahren mit dem höchsten Bestimmungskoeffizient ($R^2$) Wert unter den resultierenden Werten jeder schrittweisen Regressionsanalyse, die durch Ausführen der schrittweisen Regressionsanalyse mit mehreren Durchführungsschritten (S25) abgeleitet wurde.

**4.** Verfahren zum Vorhersagen einer Windenergiedichte nach Anspruch 1, wobei die multiple Regressionsgleichung, zur Vorhersage einer Onshore-Windenergiedichte

$$\log(\text{Windenergiedichte}) = 3{,}79969 + (0{,}05551 \times \sqrt{\text{reinterpretierte Windenergiedichte}}) + (0{,}04374 \times \sqrt{\text{Höhe}}) + (-0{,}00260 \times \sqrt{\text{Entfernung von einer Küste}}) + (-0{,}01867 \times \sqrt{\text{minimale Höhe}}) + (0{,}09367 \times \sqrt{\text{Neigung}}) + (0{,}00446 \times \text{Geländeoffenheit im Weitbereich}) + (0{,}02753 \times \sqrt{\text{mittlere Höhe}}) + (-0{,}00569 \times \text{Geländeoffenheit}) + (0{,}00075229 \times \text{relative Höhe}) + (-0{,}02608 \times \text{relative Neigung}) + (0{,}01661 \times \sqrt{\text{relatives Relief}}) + (-0{,}02137 \times \sqrt{\text{maximale Höhe}}) + (0{,}24603 \times r1) + (0{,}12644 \times r2) + (0{,}10458 \times r3) + (0{,}12340 \times r4) + (0{,}15980 \times r5) + (0{,}00345 \times r6) + (0{,}05231 \times a1) + (0{,}08932 \times a2) + (0{,}05164 \times a3) + (-0{,}00168 \times a4) + (-0{,}03096 \times a5) + (-0{,}06323 \times a6) + (-0{,}04673 \times a7)$$

ist, wobei r1 bis r6 Dummy-Variablen der Bodenrauhigkeiten und a1 bis a7 Dummy-Variablen der Aspekte sind, wobei ein Bestimmungskoeffizient ($R^2$) Wert der multiplen Regressionsgleichung, die die Onshore-Windenergiedichte des Geländes von Südkorea vorhersagt, 0,6267 beträgt.

**5.** Verfahren zum Vorhersagen einer Windenergiedichte unter Verwendung einer Hauptkomponentenanalysetechnik, die in Form eines Programms ausgebildet ist, das von einem Ausführungsverarbeitungsmittel einschließlich eines Computers ausgeführt wird, umfassend:

einen Schritt (S10) zur Eingabe einer Variablen zur Eingabe der Windenergiedichte, die Ausgabevariable ist, von Dummy-Variablen, die Aspekte (a1 bis a7) und Bodenrauhigkeiten (r1 bis r6) sind, und von zwei oder mehr Eingabevariablen, ausgewählt aus einer Höhe, einem relativen Höhenunterschied, einer Geländeoffenheit, einer Geländeoffenheit im Weitbereich, einer Neigung, einer relativen Neigung, einer mittleren Höhe, einer maximalen Höhe, einer minimalen Höhe, einem relativen Relief, einer Entfernung von einer Küste und reinterpretierten Meteorologiedaten;
einen Hauptkomponentenanalyseschritt (S20) zum Analysieren der in dem Variableneingabeschritt (S10) eingegebenen Eingabevariablen als eine Vielzahl von Hauptkomponenten durch eine Hauptkomponentenanalyse unter Verwendung von Eigenwerten und kumulierten Werten;
einen Regressionsanalyseschritt (S30) zum Durchführen einer Regressionsanalyse durch ein schrittweises Variablenauswahlverfahren unter Verwendung der Ausgabevariablen und der in dem Schritt (S10) zur Eingabe einer Variablen eingegebenen Dummy-Variablen und der als Mehrzahl von Hauptkomponenten in dem Hauptkomponentenanalyseschritt (S20) analysierten Eingabevariablen; und

einen multiplen Regressionsgleichungsschätzungsschritt (S40) zum Schätzen einer multiplen Regressionsgleichung mit dem höchsten Bestimmungskoeffizient ($R^2$) Wert unter Verwendung von Regressionskoeffizienten, die in dem Regressionsanalyseschritt (S30) berechnet wurden,

wobei der Regressionsanalyseschritt (S30) ferner einen Schritt (S32) zur Variablentransformation umfasst, zum Durchführen einer Variablentransformation der Ausgabevariablen, die in dem Schritt (S10) zur Eingabe einer Variablen eingegeben wird, umfasst, wobei die Variablentransformation eine Log-Transformation oder eine Quadratwurzeltransformation ist.

**6.** Verfahren zum Vorhersagen einer Windenergiedichte nach Anspruch 5, wobei die Bodenrauhigkeiten (r1 bis r6) Typen von Böden in Abhängigkeit von der Nutzung eines Gebietes angeben,

die Aspekte (a1 bis a7) Richtungen von geneigten Oberflächen angeben,

die Höhe (DEM) einen Höhenwert eines Gitters angibt, das von einem Gelände getrennt ist und eine vorbestimmte Größe aufweist,

die relative Höhendifferenz einen Vergleichswert zwischen einer Höhe einer Zielregion und Höhen der umliegenden Regionen angibt,

die mittlere Höhe einen Mittelwert der Höhen der Zielregion angibt,

die maximale Höhe einen Maximalwert der Höhen der Zielregion angibt,

die minimale Höhe einen Mindestwert der Höhen der Zielregion angibt,

das relative Relief eine Differenz zwischen der maximalen Höhe und der minimalen Höhe angibt,

die Geländeoffenheit einen Wert angibt, der durch Messen erhalten wird, wie viel die Zielregion nicht topologisch geschlossen ist, wenn die Zielregion und die umliegenden Regionen miteinander verglichen werden,

die Geländeoffenheit im Weitbereich einen Wert angibt, der durch Messen erhalten wird, wie viel die Zielregion nicht topologisch geschlossen ist, wenn die Zielregion mit umliegenden Regionen verglichen wird, die größer sind als die umliegenden Regionen der Geländeoffenheit,

die Neigung die am schnellsten abfallende Gefällefläche der Zielregion angibt,

die relative Neigung einen Unterschied zwischen einer ersten mittleren Neigung der Zielregion und der umliegenden Regionen und einer zweiten mittleren Neigung der umliegenden Regionen angibt, die größer sind als die umliegenden Regionen der ersten mittleren Neigung,

die Entfernung von der Küste lineare Entfernungen von einer Ostküste, einer Westküste, einer Südküste oder einer Nordküste zur Zielregion angibt, und

die reinterpretierten Meteorologiedaten globalen Wetterbeobachtungsdaten und numerischen Analysedaten entsprechen,

die in einer räumlichen Auflösung von mehreren zehn Kilometern oder mehr neu verarbeitet und für eine Wettervorhersage kostenlos bereitgestellt werden, und ausgewählt sind aus NCEP/NCAR (Nationales Zentrum für Umweltvorhersage - Nationales Zentrum für Atmosphärenforschung), MERRA (NASAs moderne retrospektive Analyse für Forschung und Anwendungen), ECMWF (Europäisches Zentrum für mittelfristige Wettervorhersagen für Europa) und JRA-25 (die 25-Jahre japanische Re-Analyse) für Japan.

**7.** Verfahren zum Vorhersagen einer Windenergiedichte nach Anspruch 5, wobei der Regressionsanalyseschritt (S30) umfasst:

einen Schritt (S31) zur Auswahl einer Variablen zum Auswählen einer oder mehrerer Hauptkomponenten, von denen der Eigenwert ein vorab eingegebener erster vorgegebener Wert oder mehr oder der kumulative Wert ist, der kleiner ist als ein vorab eingegebener zweiter vorgegebener Wert aus der Vielzahl von Hauptkomponenten, die in dem Hauptkomponentenanalyseschritt (S20) analysiert wurden;

einen Normalitätsentscheidungsschritt (S33) zum Bestimmen der Normalität der in dem Variablentransformationsschritt (S32) transformierten Ausgangsvariablen;

einen Ausgabevariableneingabeschritt (S34) zum Eingeben einer Ausgangsvariablen ausgewählt aus den Ausgangsvariablen, die in dem Schritt (S10) zur Eingabe einer Variablen eingegeben wurden und der standardisierten Ausgabevariablen, die bestimmt wurde, die Normalität im Normalitätsentscheidungsschritt (S33) aufzuweisen;

Schritt (S35) zur Eingabe einer Eingangsvariablen zum Eingeben einer oder mehrerer Eingabevariablen ausgewählt aus den Eingabevariablen, die die Hauptkomponenten konfigurieren, die in dem Variablenauswahlschritt (S31) ausgewählt wurden; und

einen Regressionsanalyse-Mehrfachdurchführungsschritt (S36) zum jeweiligen Empfangen der Ausgangsvariablen, die in dem Ausgangsvariableneingabeschritt (S34) eingegeben wurde, der Eingabevariablen, die im Eingabevariableneingabeschritt (S35) eingegeben wurde, und der Dummy-Variablen, die im Variableneingabeschritt (S10) eingegeben wurden, und das einmalige oder mehrmalige Durchführen der Regressionsanalyse durch das schrittweise Variablenauswahlverfahren.

**8.** Verfahren zum Vorhersagen einer Windenergiedichte nach Anspruch 5, wobei die Hauptkomponente multiple Regressionsgleichung, die eine Onshore-Windenergiedichte vorhersagt log(Windenergiedichte) = 4,87579 + (0,11583 × erste Hauptkomponenteneingabevariable) + (0,06275 × zweite Hauptkomponenteneingabevariable) + (0,13119 × dritte Hauptkomponenteneingabevariable) + (-0,17187 × vierte Hauptkomponenteneingabevariable) + (0,40142 × r1) + (0,24001 × r2) + (0,20801 × r3) + (0,25655 × r4) + (0,26863 × r5) + (0,08658 × r6) + (-0,11419 × a1) + (-0,05256 × a2) + (-0,06328 × a3) + (-0,09685 × a4) + (-0,10314 × a5) + (-0,11079 × a6) + (-0,06658 × a7) ist, wobei r1 bis r6 Dummy-Variablen der Bodenrauhigkeiten und a1 bis a7 Dummy-Variablen der Aspekte sind, wobei ein Bestimmungskoeffizient ($R^2$) Wert der Hauptkomponente Regressionsgleichung, die die Onshore-Windenergiedichte des Geländes von Südkorea vorhersagt, 0,5838 beträgt.

**9.** Verfahren zum Vorhersagen einer Windenergiedichte unter Verwendung einer neuronalen Netzwerkanalyse-Technik, die in Form eines Programms ausgebildet ist, das von einem Ausführungsverarbeitungsmittel einschließlich eines Computers ausgeführt wird, umfassend:

einen Schritt (S100) zur Eingabe einer Variablen zur Eingabe der Windenergiedichte, die eine Ausgabevariable ist, sowie von zwei oder mehr Eingabevariablen, ausgewählt aus Bodenrauhigkeiten (r1 bis r6), einer Höhe, einem relativen Höhenunterschied, einer Geländeoffenheit, einer Geländeoffenheit im Weitbereich, Aspekten (a1 bis a7), einer Neigung, einer relativen Neigung, einer mittleren Höhe, einer maximalen Höhe, einer minimalen Höhe, einem relativen Relief, einer Entfernung von einer Küste und reinterpretierten Meteorologiedaten;
einen neuronalen Netzwerkanalyseschritt (S200) zum Durchführen einer neuronalen Netzwerkanalyse unter Verwendung der Ausgangsvariablen, die in dem Schritt (S100) zur Eingabe einer Variablen eingegeben wurden und der durch ein schrittweises Variablenauswahlverfahren ausgewählten Eingabevariablen; und
einen neuronalen Netzwerk-Modellschätzungsschritt (S300) zum Schätzen eines neuronalen Netzwerkanalysemodells durch einen Wert eines Korrelationskoeffizienten unter Verwendung einer Anzahl von versteckten Knoten in Abhängigkeit von einem RMSE-Wert (Root Mean Square Error), der in dem neuronalen Netzwerkanalyseschritt (S200) berechnet wurde,
einen neuronalen Netzwerk-Modellschätzungsschritt (S300) zum Schätzen eines neuronalen Netzwerkanalysemodells durch einen Wert eines Korrelationskoeffizienten unter Verwendung einer Anzahl von versteckten Knoten in Abhängigkeit von einem RMSE-Wert (Root Mean Square Error), der in dem neuronalen Netzwerkanalyseschritt (S200) berechnet wurde,
wobei in dem neuronalen Netzwerkanalyseschritt (S200) die Ausgangsvariable, die in dem Schritt (S100) zur Eingabe einer Variablen eingegeben wurde, in einer ursprünglichen Variablenform verwendet wird oder eine Variablentransformation der Ausgangsvariablen, die in dem Schritt (S100) zur Eingabe einer Variablen eingegeben wurde, durchgeführt wird, wobei die Variablentransformation eine Log-Transformation oder eine Quadratwurzeltransformation ist.

**10.** Verfahren zum Vorhersagen einer Windenergiedichte nach Anspruch 9, wobei die Bodenrauhigkeiten (r1 bis r6) des Schrittes (S100) zur Eingabe von Variablen Typen von Böden abhängig von der Nutzung eines Gebietes angeben,
die Aspekte (a1 bis a7) Richtungen von geneigten Oberflächen angeben und
die Bodenrauhigkeiten und die Aspekte in Dummy-Variablen umgewandelt werden.

**11.** Verfahren zum Vorhersagen einer Windenergiedichte nach Anspruch 9, wobei der Analyseschritt (S200) des neuronalen Netzwerks einen ersten Analyseschritt (S210) zum Durchführen der neuronalen Netzwerkanalyse unter Verwendung der log-transformierten Ausgangsvariablen und der Eingabevariablen unter Verwendung des schrittweisen Variablenauswahlverfahrens umfasst.

**12.** Verfahren zum Vorhersagen einer Windenergiedichte nach Anspruch 9, wobei der Analyseschritt (S200) des neuronalen Netzwerks einen zweiten Analyseschritt (S220) zum Durchführen der neuronalen Netzwerkanalyse unter Verwendung der Ausgangsvariablen in einer Originaldatenform und der Eingabevariablen unter Verwendung des schrittweisen Variablenauswahlverfahrens umfasst.

**13.** Verfahren zum Vorhersagen einer Windenergiedichte nach Anspruch 9, wobei der Analyseschritt (S200) des neuronalen Netzwerks einen dritten Analyseschritt (S230) zum Durchführen der neuronalen Netzwerkanalyse unter Verwendung der quadratwurzeltransformierten Ausgangsvariablen und der Eingabevariablen unter Verwendung des schrittweisen Variablenauswahlverfahrens umfasst.

**14.** Verfahren zum Vorhersagen einer Windenergiedichte nach Anspruch 9, wobei der Analyseschritt (S200) des neuronalen Netzwerks einen vierten Analyseschritt (S240)zum Durchführen der neuronalen Netzwerkanalyse unter Verwendung der log-transformierten Ausgangsvariablen und der Eingabevariablen unter Verwendung des schrittweise Variablenauswahlverfahrens umfasst, und
die Höhe, die Neigung, die Entfernung von der Küste, die maximale Höhe, die mittlere Höhe, die minimale Höhe, die relative Höhe, das Relief und die reinterpretierten Meteorologiedaten quadratwurzeltransformiert sind.

**15.** Verfahren zum Vorhersagen einer Windenergiedichte nach Anspruch 9, wobei der Analyseschritt (S200) für das neuronale Netzwerk einen fünften Analyseschritt (S250) zum Durchführen der Analyse des neuronalen Netzwerks unter Verwendung der quadratwurzeltransformierten Ausgangsvariablen und der Eingabevariablen unter Verwendung des schrittweisen Variablenauswahlverfahrens umfasst, und
die Höhe, die Neigung, die Entfernung von der Küste, die maximale Höhe, die mittlere Höhe, die minimale Höhe, das relative Relief und die reinterpretierten Meteorologiedaten quadratwurzeltransformiert sind.

**Revendications**

**1.** Procédé de prédiction d'une densité d'énergie éolienne utilisant une technique d'analyse de régression par étapes, configurée sous la forme d'un programme exécuté par un moyen de traitement d'exécution comprenant un ordinateur, comprenant:

une étape d'entrée de variables (S1) consistant à entrer la densité d'énergie éolienne, qui est une variable de sortie, et deux ou plusieurs variables d'entrée choisies parmi rugueurs du sol (r1 à r6), une élévation, une différence d'élévation relative, une ouverture de terrain, une ouverture de terrain de région large, aspects (a1 à a7), une pente, une pente relative, une élévation moyenne, une élévation maximale, une élévation minimale, un relief relatif, une distance depuis une côte, et données de réinterprétation météorologiques;
une étape d'analyse de régression par étapes (S2) consistant à recevoir la variable de sortie et les variables d'entrée entrées dans l'étape d'entrée de variables (S1) et exécuter une procédé d'analyse de régression par un procédé de sélection de variable par étapes; et
une étape d'estimation d'équation de régression multiple (S3) consistant à estimer une équation de régression multiple ayant la valeur de coefficient de détermination (R2) la plus élevée en utilisant des coefficients de régression calculés dans l'étape d'analyse de régression par étapes (S2),
dans lequel l'étape d'analyse de régression par étapes (S2) comprend en outre une étape de transformation de variables (S21) consistant à transformer des variables d'entrée en utilisant des variables nominales parmi la variable de sortie et les variables d'entrée entrées dans l'étape d'entrée de variables (S1) en variables factices, tout en utilisant chacune de la variable de sortie et des variables d'entrée sous une forme de variable originale ou en effectuant une transformation de variable de chacune de la variable de sortie et des variables d'entrée, la transformation de variable étant une transformation log ou une transformation de racine carrée.

**2.** Procédé de prédiction d'une densité d'énergie éolienne selon la revendication 1, dans lequel les rugueurs du sol (r1 à r6) indiquent des types de sols en fonction de l'utilisation d'un terrain,
les aspects (a1 à a7) indiquent directions de surfaces inclinées,
l'élévation (DEM) indique une valeur d'élévation d'un treillis divisé d'un terrain et ayant une taille prédéterminée,
la différence d'élévation relative indique une valeur de comparaison entre une élévation d'une région cible et élévations des régions environnantes,
l'élévation moyenne indique une moyenne des élévations de la région cible,
l'élévation maximale indique une valeur maximale des élévations de la région cible,
l'élévation minimale indique une valeur minimale des élévations de la région cible,
le relief relatif indique une différence entre l'élévation maximale et l'élévation minimale,
l'ouverture de terrain indique une valeur obtenue en mesurant dans quelle mesure la région cible n'est pas topologiquement fermée lorsque la région cible et les régions environnantes sont comparées entre elles,
l'ouverture de terrain de région large indique une valeur obtenue en mesurant dans quelle mesure la région cible n'est pas topologiquement fermée lorsque la région cible est comparée aux régions environnantes plus larges que les régions environnantes de l'ouverture de terrain,

la pente indique la surface de descente la plus rapide de la région cible,
la pente relative indique une différence entre une première pente moyenne de la région cible et les régions environnantes et une deuxième pente moyenne des régions environnantes plus larges que les régions environnantes de la première pente moyenne,
la distance depuis la côte indique distances linéaires entre une côte est, une côte ouest, une côte sud ou une côte nord et la région cible, et
les données de réinterprétation météorologiques correspondent à des données d'observation météorologique globale et à des données d'analyse numérique retraitées à une résolution spatiale de plusieurs dizaines de kilomètres ou plus et distribuées gratuitement pour une prévision météorologique, et est l'un ou l'autre NCEP/NCAR (National Center for Environmental Prediction-National Center for Atmospheric Research), MERRA (NASA's Modern-Era Retrospective Analysis for Research et Applications), ECMWF (European Center for Medium-range Weather Forecasts) d'Europe , et JRA-25 (The 25-year Japanese ReAnalysis) du Japon.

**3.** Procédé de prédiction d'une densité d'énergie éolienne selon la revendication 1, dans lequel l'étape d'analyse de régression par étapes (S2) comprend:

une étape de détermination de normalité (S22) consistant à déterminer la normalité de chacune de la variable de sortie et des variables d'entrée transformées dans l'étape de transformation de variables (S21);
une étape d'entrée de variable de sortie (S23) consistant à entrer l'une quelconque sélectionnée parmi la variable de sortie entrées dans l'étape d'entrée de variables (S1) et la variable de sortie transformée décidé comme ayant la normalité dans l'étape de détermination de normalité (S22);
une étape d'entrée de variable d'entrée (S24) consistant à entrer variables d'entrée obtenues en transformant des variables d'entrée en utilisant variables nominales en variables factices dans l'étape de transformation de variables (S21) et en entrant l'une quelconque choisies parmi variables d'entrée des mêmes composantes des variables d'entrée qui ne sont pas les variables nominales entrées dans l'étape d'entrée de variables (S1) et les variables d'entrée transformées décidés comme ayant la normalité dans l'étape de détermination de normalité (S22) pour variable d'entrée entrée dans l'étape d'entrée de variables (S1);
une étape d'exécution d'analyse de régression par étapes multiple (S25) consistant à recevoir la variable de sortie entrée dans l'étape d'entrée de variable de sortie (S23) et les variables d'entrée entrées dans l'étape d'entrée de variable d'entrée (S24), respectivement, et à exécuter le procédé d'analyse de régression par le procédé de sélection de variable par étapes une ou plusieurs fois; et
une étape de sélection de données d'analyse de régression par étapes optimale (S26) consistant à sélectionner un résultat d'analyse de régression par le procédé de sélection de variable par étapes ayant la valeur de coefficient de détermination (R2) la plus élevée parmi valeurs résultantes de chaque analyse de régression par étapes dérivée en effectuant l'étape d'exécution d'analyse de régression par étapes multiple (S25).

**4.** Procédé de prédiction d'une densité d'énergie éolienne selon la revendication 1, dans lequel l'équation de régression multiple prédisant une densité d'énergie éolienne terrestre est

$$\log(\text{densité d'énergie éolienne}) = 3.79969 + (0.05551 \times \sqrt{\text{réinterprétation de densité d'énergie éolienne}}) + (0.04374 \times \sqrt{\text{élévation}} + (-0.00260 \times \sqrt{\text{distance depuis côte}}) + (-0.01867 \times \sqrt{\text{élévation minimale}}) + (0.09367 \times \sqrt{\text{pente}} + (0.00446 \times \text{ouverture de terrain de région large}) + (0.02753 \times \sqrt{\text{élévation moyenne}}) + (-0.00569 \times \text{ouverture de terrain}) + (0.00075229 \times \text{relative élévation}) + (-0.02608 \times \text{pente relative}) + (0.01661 \times \sqrt{\text{relief relatif}}) + (-0.02137 \times \sqrt{\text{élévation maximale}}) + (0.24603 \times r1) + (0.12644 \times r2) + (0.10458 \times r3) + (0.12340 \times r4) + (0.15980 \times r5) + (0.00345 \times r6) + (0.05231 \times a1) + (0.08932 \times a2) + (0.05164 \times a3) + (-0.00168 \times a4) + (-0.03096 \times a5) + (-0.06323 \times a6) + (-0.04673 \times a7),$$

où r1 à r6 sont variables factices des rugueurs du sol et a1 à a7 sont variables factices des aspects, dans lequel une valeur de coefficient de détermination (R2) de l'équation de régression multiple prédisant la densité d'énergie éolienne terrestre du terrain de la Corée du Sud est 0.6267.

**5.** Procédé de prédiction d'une densité d'énergie éolienne en utilisant une technique d'analyse en composantes principales, configurée sous la forme d'un programme exécuté par un moyen de traitement d'exécution comprenant un ordinateur, comprenant:

une étape d'entrée de variables (S10) consistant à entrer la densité d'énergie éolienne, qui est une variable de sortie, variables factices, qui sont aspects (a1 à a7) et rugueurs du sol (r1 à r6), et deux ou plusieurs variables d'entrée choisies parmi une élévation, une différence d'élévation relative, une ouverture de terrain, une ouverture de terrain de région large, une pente, une pente relative, une élévation moyenne, une élévation maximale, une élévation minimale, un relief relatif, une distance depuis une côte, et données de réinterprétation météorologiques;
une étape d'analyse en composant principal (S20) consistant à analyser les variables d'entrée entrées dans l'étape d'entrée de variables (S10) en tant que plusieurs composants principaux par une analyse en composant principal en utilisant valeurs propres et valeurs cumulées;
une étape d'analyse de régression (S30) consistant à effectuer une analyse de régression par un procédé de sélection de variable par étapes en utilisant la variable de sortie et les variables factices entrées dans l'étape d'entrée de variables (S10) et les variables d'entrée analysées comme la pluralité des composants principaux dans l'étape d'analyse en composant principal (S20); et
une étape de estimation d'équation de régression multiple (S40) consistant à estimer une équation de régression multiple ayant la valeur de coefficient de détermination (R2) la plus élevée en utilisant des coefficients de régression calculés dans l'étape d'analyse de régression (S30),
dans lequel l'étape d'analyse de régression (S30) comprend en outre une étape de transformation de variables (S32) consistant à effectuer une transformation de variable de la variable de sortie entrées dans l'étape d'entrée de variables (S10), la transformation de variable étant une transformation log or une transformation de racine carrée.

**6.** Procédé de prédiction d'une densité d'énergie éolienne selon la revendication 5, dans lequel
les rugueurs du sol (r1 à r6) indiquent des types de sols en fonction de l'utilisation d'un terrain,
les aspects (a1 à a7) indiquent directions de surfaces inclinées,
l'élévation (DEM) indique une valeur d'élévation d'un treillis divisé d'un terrain et ayant une taille prédéterminée,
la différence d'élévation relative indique une valeur de comparaison entre une élévation d'une région cible et élévations des régions environnantes,
l'élévation moyenne indique une moyenne des élévations de la région cible,
l'élévation maximale indique une valeur maximale des élévations de la région cible, l'élévation minimale indique une valeur minimale des élévations de la région cible,
le relief relatif indique une différence entre l'élévation maximale et l'élévation minimale,
l'ouverture de terrain indique une valeur obtenue en mesurant dans quelle mesure la région cible n'est pas topologiquement fermée lorsque la région cible et les régions environnantes sont comparées entre elles,
l'ouverture de terrain de région large indique une valeur obtenue en mesurant dans quelle mesure la région cible n'est pas topologiquement fermée lorsque la région cible est comparée aux régions environnantes plus larges que les régions environnantes de l'ouverture de terrain,
la pente indique la surface de descente la plus rapide de la région cible,
la pente relative indique une différence entre une première pente moyenne de la région cible et les régions environnantes et une deuxième pente moyenne des régions environnantes plus larges que les régions environnantes de la première pente moyenne,
la distance depuis la côte indique distances linéaires entre une côte est, une côte ouest, une côte sud ou une côte nord et la région cible, et
les données de réinterprétation météorologiques correspondent à des données d'observation météorologique globale et à des données d'analyse numérique retraitées à une résolution spatiale de plusieurs dizaines de kilomètres ou plus et distribuées gratuitement pour une prévision météorologique, et est l'un ou l'autre NCEP/NCAR (National Center for Environmental Prediction-National Center for Atmospheric Research), MERRA (NASA's Modern-Era Retrospective Analysis for Research et Applications), ECMWF (European Center for Medium-range Weather Forecasts) d'Europe , et JRA-25 (The 25-year Japanese ReAnalysis) du Japon.

**7.** Procédé de prédiction d'une densité d'énergie éolienne selon la revendication 5, dans lequel l'étape d'analyse de régression (S30) comprend:

une étape de sélection de variable (S31) consistant à sélectionner un ou plusieurs composants principaux dont la valeur propre est une première valeur prédéterminée de pré-entrée ou plus ou la valeur cumulative est inférieure à une seconde valeur prédéterminée de pré-entrée parmi la pluralité des composants principaux analysés dans l'étape d'analyse en composant principal (S20);
une étape de détermination de normalité (S33) consistant à décider normalité de la variable de sortie transformée dans l'étape de transformation de variables (S32);
une étape d'entrée de variable de sortie (S34) consistant à entrer l'une quelconque sélectionnée parmi la variable de sortie entrées dans l'étape d'entrée de variables (S10) et variable de sortie normalisée décidé comme ayant la normalité dans l'étape de détermination de normalité (S33);
une étape d'entrée de variable d'entrée (S35) consistant à entrer une ou plusieurs choisies parmi les variables d'entrée configurant les composants principaux sélectionnés dans l'étape de sélection de variable (S31); et
une étape d'exécution multiple d'analyse de régression (S36) consistant à recevoir la variable de sortie entrée dans l'étape d'entrée de variable de sortie (S34), la variable d'entrée entrée dans l'étape d'entrée de variable d'entrée (S35), et les variables factices entrées dans l'étape d'entrée de variables (S10), respectivement, et effectuer l'analyse de régression par le procédé de sélection de variable par étapes une ou plusieurs fois.

**8.** Procédé de prédiction d'une densité d'énergie éolienne selon la revendication 5, dans lequel l'équation de régression multiple à composantes principales prédisant une densité d'énergie éolienne terrestre est log(densité d'énergie éolienne) = 4.87579 + (0.11583 $\times$ première variable d'entrée de composante principale) + (0.06275 $\times$ deuxième variable d'entrée de composante principale) + (0.13119 $\times$ troisième variable d'entrée de composante principale) + (-0.17187 $\times$ quatrième variable d'entrée de composante principale) + (0.40142 $\times$ r1) + (0.24001 $\times$ r2) + (0.20801 $\times$ r3) + (0.25655 $\times$ r4) + (0.26863 $\times$ r5) + (0.08658 $\times$ r6) + (-0.11419 $\times$ a1) + (-0.05256 $\times$ a2) + (-0.06328 $\times$ a3) + (-0.09685 $\times$ a4) + (-0.10314 $\times$ a5) + (-0.11079 $\times$ a6) + (-0.06658 $\times$ a7),
où r1 à r6 sont variables factices des rugueurs du sol et a1 à a7 sont variables factices des aspects, dans lequel une valeur de coefficient de détermination (R2) de l'équation de régression du composant principal prédisant la densité d'énergie éolienne terrestre du terrain de la Corée du Sud est 0.5838.

**9.** Procédé de prédiction d'une densité d'énergie éolienne en utilisant une technique d'analyse de réseau neuronal, configurée sous la forme d'un programme exécuté par un moyen de traitement d'exécution comprenant un ordinateur, comprenant:

une étape d'entrée de variables (S100) consistant à entrer la densité d'énergie éolienne, qui est une variable de sortie, et deux ou plusieurs variables d'entrée choisies parmi rugueurs du sol (r1 à r6), une élévation, une différence d'élévation relative, une ouverture de terrain, une ouverture de terrain de région large, aspects (a1 à a7), une pente, une pente relative, une élévation moyenne, une élévation maximale, une élévation minimale, un relief relatif, une distance depuis une côte, et données de réinterprétation météorologiques;
une étape d'analyse de réseau neuronal (S200) consistant à effectuer une analyse de réseau neuronal en utilisant la variable de sortie entrée dans l'étape d'entrée de variables (S100) et les variables d'entrée sélectionnées par un procédé de sélection de variable par étapes; et
une étape d'estimation d'un modèle de réseau neuronal (S300) consistant à estimer un modelé d'analyse de réseau neuronal par une valeur de coefficient de détermination en utilisant le nombre de noeuds cachés en fonction d'une valeur d'erreur quadratique moyenne quadratique (RMSE) calculée dans l'étape d'analyse de réseau neuronal (S200),
dans lequel dans l'étape d'analyse de réseau neuronal (S200), la variable de sortie entrée dans l'étape d'entrée de variables (S100) est utilisée sous une forme de variable originale ou une transformation de variable de la variable de sortie entrée dans l'étape d'entrée de variables (S100) est effectuée, la transformation de variable étant une transformation log or une transformation de racine carrée.

**10.** Procédé de prédiction d'une densité d'énergie éolienne selon la revendication 9, dans lequel les rugueurs du sol (r1 à r6) de l'étape d'entrée de variables (S100) indiquent des types de sols en fonction de l'utilisation d'un terrain, les aspects (a1 à a7) indiquent directions de surfaces inclinées, et
les rugueurs du sol et les aspects sont transformés en variables factices.

**11.** Procédé de prédiction d'une densité d'énergie éolienne selon la revendication 9, dans lequel l'étape d'analyse de réseau neuronal (S200) comprend une première étape d'analyse (S210) consistant à effectuer l'analyse de réseau neuronal en utilisant la variable de sortie transformée-log et la variable d'entrée en utilisant le procédé de sélection de variables par étapes.

**12.** Procédé de prédiction d'une densité d'énergie éolienne selon la revendication 9, dans lequel l'étape d'analyse de réseau neuronal (S200) comprend une deuxième étape d'analyse (S220) consistant à effectuer l'analyse de réseau neuronal en utilisant la variable de sortie sous une forme de donnée originale et la variable d'entrée en utilisant le procédé de sélection de variables par étapes.

**13.** Procédé de prédiction d'une densité d'énergie éolienne selon la revendication 9, dans lequel l'étape d'analyse de réseau neuronal (S200) comprend une troisième étape d'analyse (S230)consistant à effectuer l'analyse de réseau neuronal en utilisant la variable de sortie transformée en racine carrée et la variable d'entrée en utilisant le procédé de sélection de variables par étapes.

**14.** Procédé de prédiction d'une densité d'énergie éolienne selon la revendication 9, dans lequel l'étape d'analyse de réseau neuronal (S200) comprend une quatrième étape d'analyse (S240)consistant à effectuer l'analyse de réseau neuronal en utilisant la variable de sortie transformée-log et la variable d'entrée en utilisant le procédé de sélection de variables par étapes, et
l'élévation, la pente, la distance depuis la côte, l'élévation maximale, l'élévation moyenne, l'élévation minimale, le relief relatif, et les données de réinterprétation météorologiques sont transformées en racine carrée.

**15.** Procédé de prédiction d'une densité d'énergie éolienne selon la revendication 9, dans lequel l'étape d'analyse de réseau neuronal (S200) comprend une cinquième étape d'analyse (S250) consistant à effectuer l'analyse de réseau neuronal en utilisant la variable de sortie transformée en racine carrée et la variable d'entrée en utilisant le procédé de sélection de variables par étapes, et
l'élévation, la pente, la distance depuis la côte, l'élévation maximale, l'élévation moyenne, l'élévation minimale, le relief relatif, et les données de réinterprétation météorologiques sont transformées en racine carrée.

【FIG. 1】

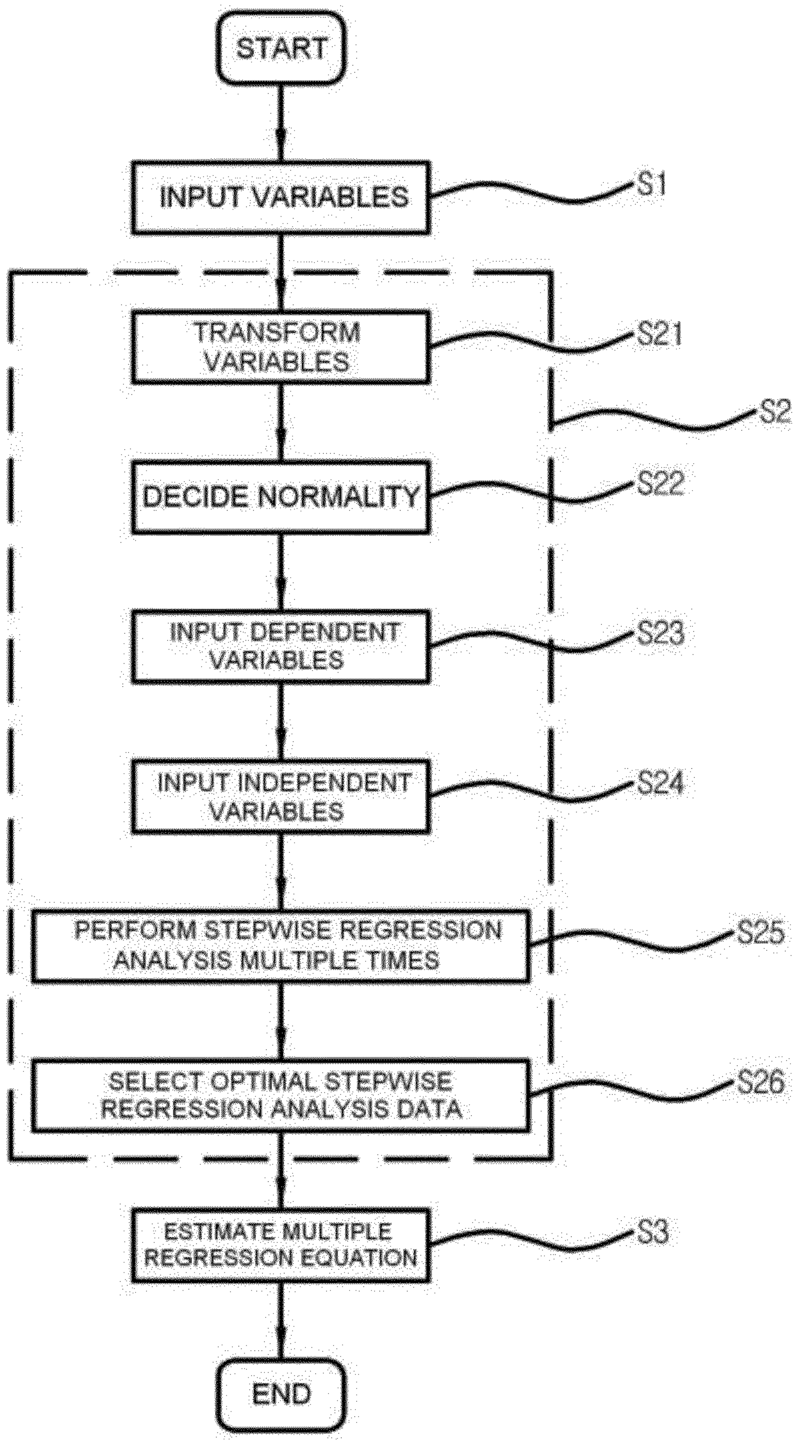
START
INPUT VARIABLES
S1
TRANSFORM VARIABLES
S21
S2
DECIDE NORMALITY
S22
INPUT DEPENDENT VARIABLES
S23
INPUT INDEPENDENT VARIABLES
S24
PERFORM STEPWISE REGRESSION ANALYSIS MULTIPLE TIMES
S25
SELECT OPTIMAL STEPWISE REGRESSION ANALYSIS DATA
S26
ESTIMATE MULTIPLE REGRESSION EQUATION
S3
END

【FIG. 2】

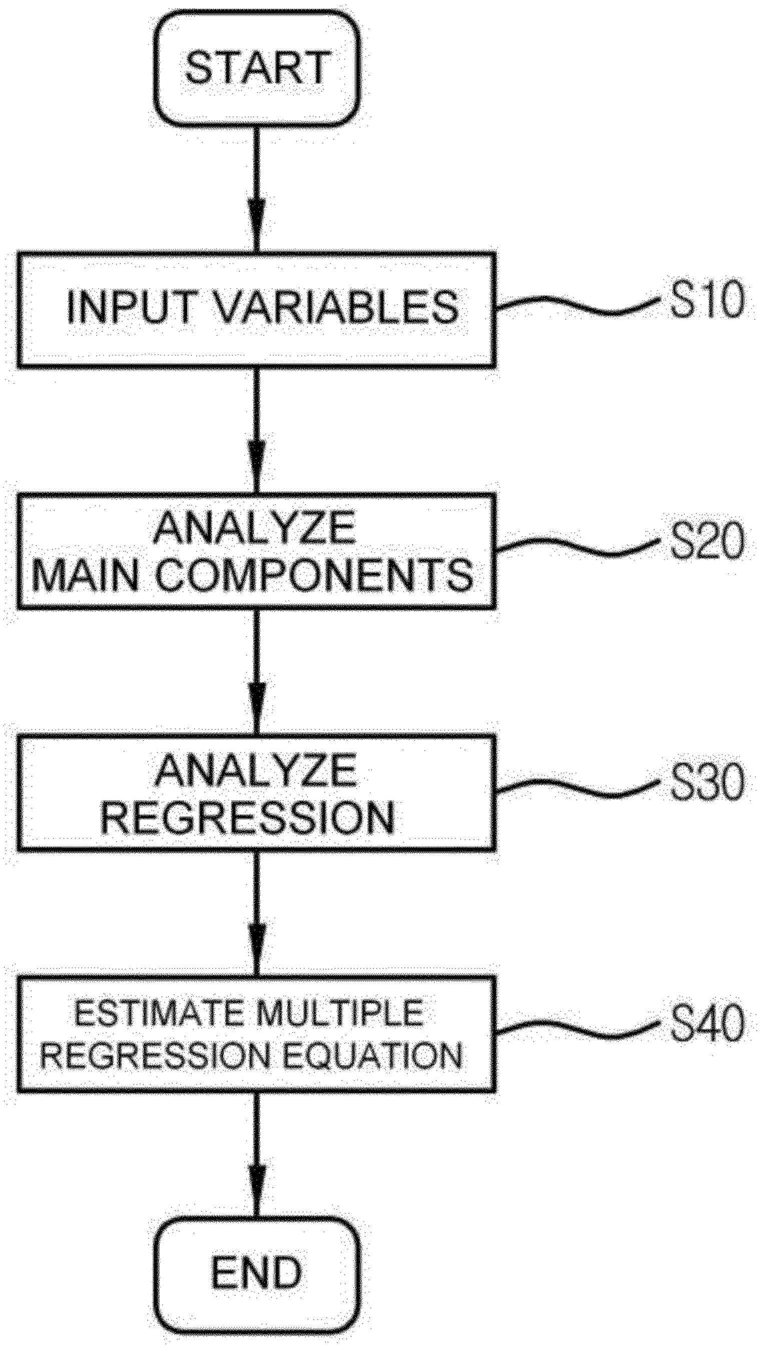
START
INPUT VARIABLES
S10
ANALYZE
MAIN COMPONENTS
S20
ANALYZE
REGRESSION
S30
ESTIMATE MULTIPLE
REGRESSION EQUATION
S40
END

【FIG. 3】

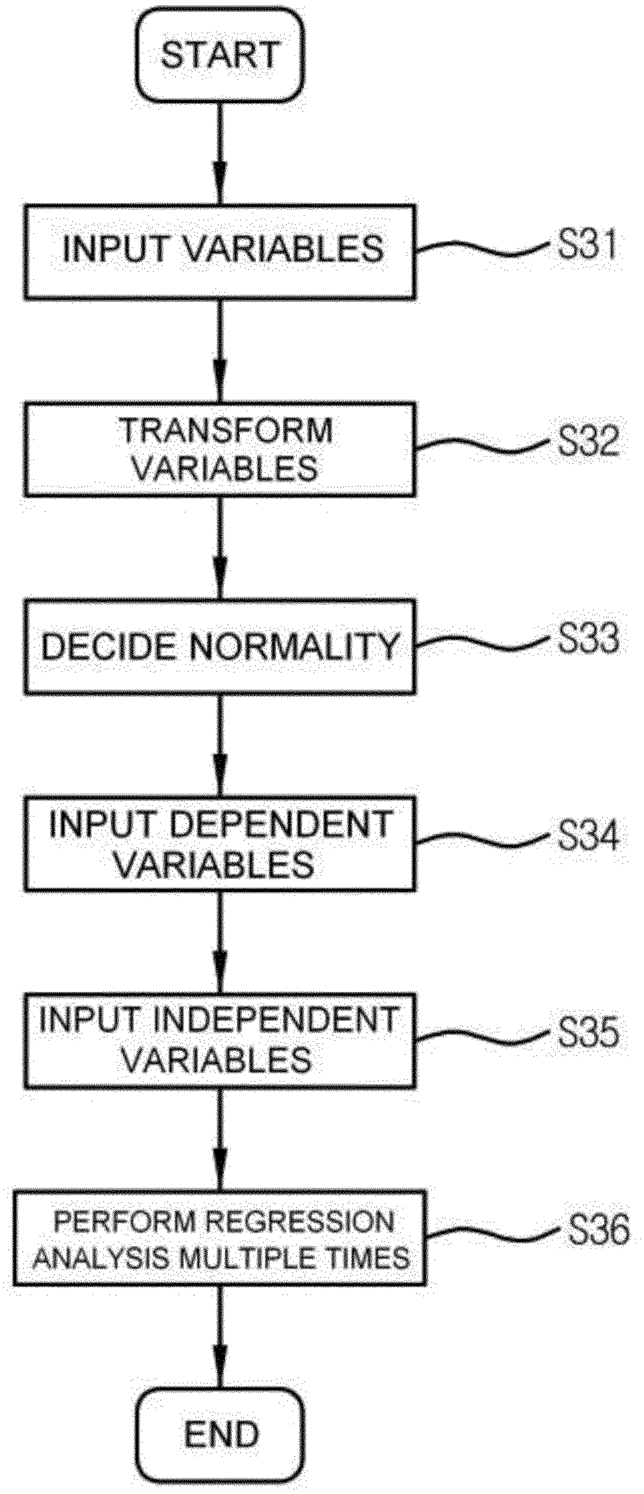
START
INPUT VARIABLES
S31
TRANSFORM VARIABLES
S32
DECIDE NORMALITY
S33
INPUT DEPENDENT VARIABLES
S34
INPUT INDEPENDENT VARIABLES
S35
PERFORM REGRESSION ANALYSIS MULTIPLE TIMES
S36
END

【FIG. 4】

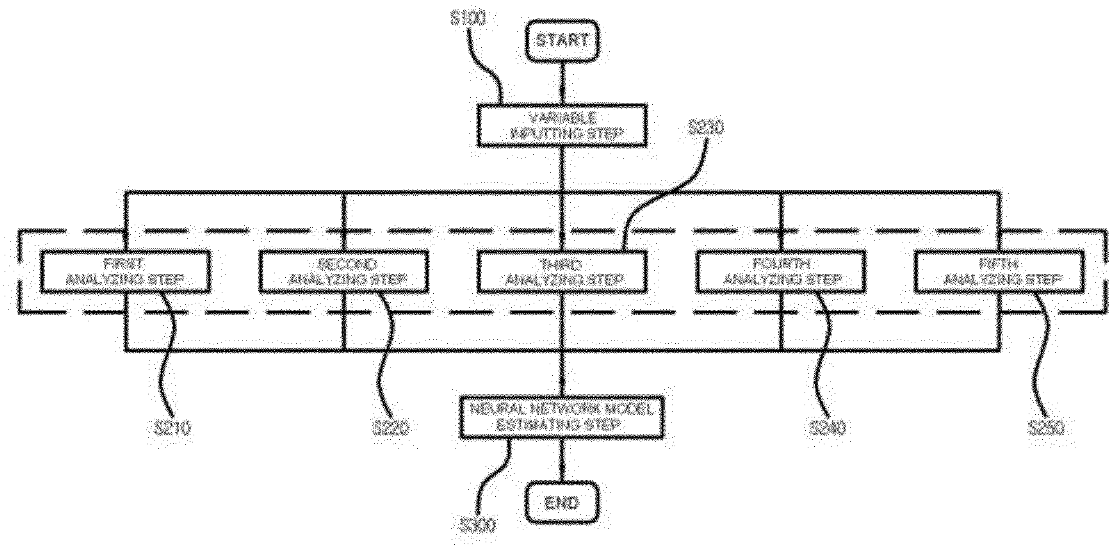
S100
START
VARIABLE INPUTTING STEP
S230
FIRST ANALYZING STEP
SECOND ANALYZING STEP
THIRD ANALYZING STEP
FOURTH ANALYZING STEP
FIFTH ANALYZING STEP
S210
S220
NEURAL NETWORK MODEL ESTIMATING STEP
S240
S250
S300
END

【FIG. 5】

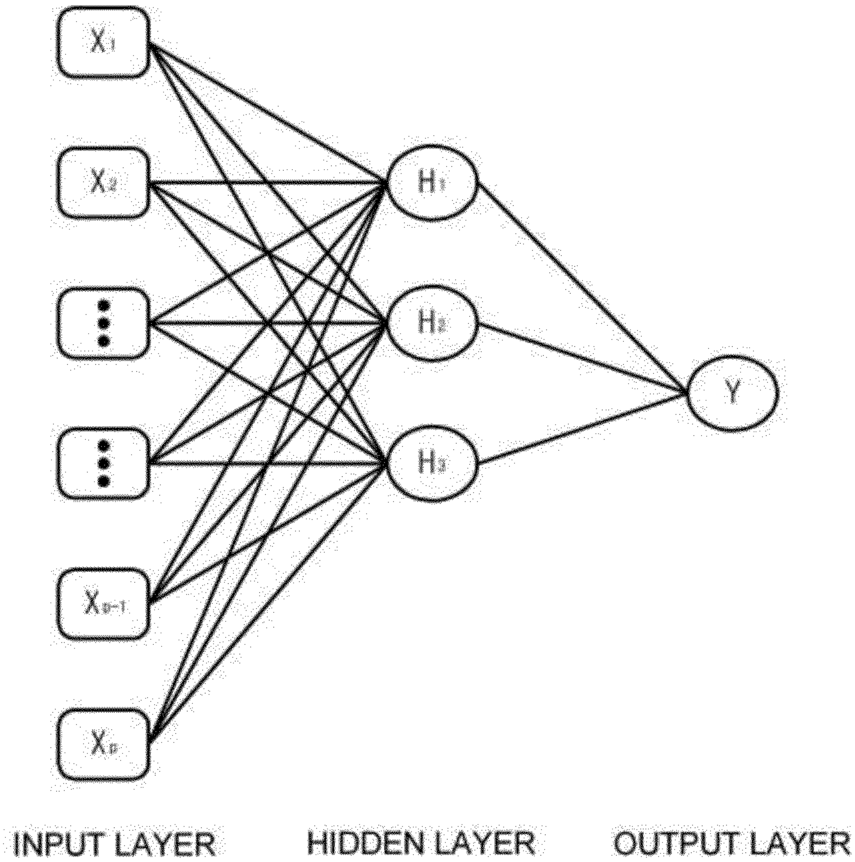
X1
X2
Xp-1
Xp
H1
H2
H3
Y
INPUT LAYER
HIDDEN LAYER
OUTPUT LAYER

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 101020638
- KR 20050063616


### Non-patent literature cited in the description


- Comparative analysis of regression and artificial neural network models for wind speed prediction. *Meteorol Atmos Phys,* 2010, vol. 109, 61-72